(19) Europäisches Patentamt / European Patent Office / Office européen des brevets

(11) **EP 3 792 333 A1**

(12) **EUROPEAN PATENT APPLICATION**
published in accordance with Art. 153(4) EPC

(43) Date of publication:
**17.03.2021 Bulletin 2021/11**

(51) Int Cl.:
***C09K 11/64*** (2006.01)  ***H01L 33/50*** (2010.01)

(21) Application number: **19800771.8**

(22) Date of filing: **08.04.2019**

(86) International application number:
**PCT/JP2019/015318**

(87) International publication number:
**WO 2019/216083 (14.11.2019 Gazette 2019/46)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **09.05.2018 JP 2018090854**

(71) Applicant: Hitachi High-Tech Corporation
Minato-ku
Tokyo 105-6409 (JP)

(72) Inventors:
• KOMATSU Masaaki
  Tokyo 100-8280 (JP)
• IMAMURA Shin
  Tokyo 100-8280 (JP)
• ISHIDA Takeshi
  Tokyo 100-8280 (JP)
• YAMAZAKI Isao
  Tokyo 105-8717 (JP)
• ASO Sadamitsu
  Tokyo 105-8717 (JP)

(74) Representative: Strehl Schübel-Hopf & Partner
Maximilianstrasse 54
80538 München (DE)

(54) **FLUORESCENT BODY, LIGHT SOURCE, AND BIOCHEMICAL ANALYZER**

(57) The present invention improves the performance of an analyzer and facilitates the maintenance of the analyzer. This fluorescent body is produced by firing a raw material which contains: an alumina; and at least one among Fe, Cr, Bi, Tl, Ce, Tb, Eu, and Mn, wherein the raw material contains 6.1-15.9 wt% of sodium with respect to the total amount of the raw material.

FIG. 2

| Item | Composition | Raw material composition | | | | |
|---|---|---|---|---|---|---|
| | | $BaCO_3$ (g) | $Na_2CO_3$ (g) | $Al_2O_3$ (g) | $FeCl_2 \cdot 4H_2O$ (mg) | Flux (mg) |
| Comparative Example 1 | $BaAl_{12}O_{19}{:}Fe(\alpha\text{-alumina})$ | 1.22 | - | 3.77 | 10 | 5 |
| Comparative Example 2 | $BaAl_{12}O_{19}{:}Fe(\text{fired alumina})$ | 1.22 | - | 3.65 | 120 | 5 |
| Comparative Example 3 | $BaAl_{12}O_{19}{:}Fe(\text{fired alumina})$ | 0.47 | - | 1.45 | 47 | 27 |
| Comparative Example 4 | $BaAl_{12}O_{19}{:}Fe(\text{fired alumina})$ | 0.43 | - | 1.49 | 24 | 55 |
| Comparative Example 5 | $BaAl_{12}O_{19}{:}Fe(\text{fired alumina})$ | 0.38 | - | 1.48 | 24 | 110 |
| Comparative Example 6 | $BaAl_{12}O_{19}{:}Fe(\text{fired alumina})$ | 0.39 | - | 1.49 | 8 | 110 |
| Comparative Example 7 | $BaAl_{12}O_{19}{:}Fe(\text{fired alumina})$ | 0.48 | - | 1.49 | 10 | 25 |
| Comparative Example 8 | $BaAl_{12}O_{19}{:}Fe(\text{fired alumina})$ | 0.39 | - | 1.50 | 4.9 | 111 |
| Comparative Example 9 | $BaAl_{12}O_{19}{:}Fe(\text{fired alumina})$ | 0.39 | - | 1.50 | 2.5 | 111 |
| Comparative Example 10 | $Na\text{-}nAl_2O_3{:}Fe(\text{fused alumina})$ | | 0.42 | 0.92 | 36 | 190 |
| Comparative Example 11 | $Na\text{-}nAl_2O_3{:}Fe(\text{fused alumina})$ | | 2.17 | 2.32 | 41 | 470 |
| Comparative Example 12 | $Na\text{-}nAl_2O_3{:}Fe(\beta\text{-alumina})$ | - | 1.08 | 1.15 | 9 | 260 |
| Example 1 | $BaAl_{12}O_{19}{:}Fe(\beta\text{-alumina})$ | 0.38 | - | 1.48 | 30 | 110 |
| Example 2 | $BaAl_{12}O_{19}{:}Fe(\beta\text{-alumina})$ | 0.38 | - | 1.48 | 47 | 110 |
| Example 3 | $BaAl_{12}O_{19}{:}Fe(\beta\text{-alumina})$ | 0.43 | - | 1.45 | 47 | 55 |
| Example 4 | $BaAl_{12}O_{19}{:}Fe(\beta\text{-alumina})$ | 0.43 | - | 1.49 | 8 | 55 |
| Example 5 | $BaAl_{12}O_{19}{:}Fe(\beta\text{-alumina})$ | 0.43 | - | 1.48 | 24 | 55 |
| Example 6 | $Na\text{-}nAl_2O_3{:}Fe(\beta\text{-alumina})$ | - | 0.42 | 1.11 | 8 | 55 |
| Example 7 | $Na\text{-}nAl_2O_3{:}Fe(\beta\text{-alumina})$ | - | - | 1.11 | 8 | 55 |
| Example 8 | $Na\text{-}nAl_2O_3{:}Fe(\beta\text{-alumina})$ | - | 0.27 | 1.15 | 9 | 260 |
| Example 9 | $Na\text{-}nAl_2O_3{:}Fe(\beta\text{-alumina})$ | - | 0.27 | 1.15 | 23 | 260 |
| Example 10 | $Na\text{-}nAl_2O_3{:}Fe(\beta\text{-alumina})$ | - | 0.27 | 1.15 | 23 | - |
| Example 11 | $Na\text{-}nAl_2O_3{:}Fe(\beta\text{-alumina})$ | - | 0.27 | 1.15 | 23 | 260 |
| Example 12 | $Na\text{-}nAl_2O_3{:}Fe(\beta\text{-alumina})$ | - | 0.27 | 1.15 | 23 | 260 |
| Example 13 | $Na\text{-}nAl_2O_3{:}Fe(\text{fired alumina})$ | - | 0.42 | 1.11 | 8 | 210 |

| Item | Composition | Raw material composition | | | | |
|---|---|---|---|---|---|---|
| | | $CaCO_3$ (g) | $Na_2CO_3$ (g) | $Al_2O_3$ (g) | $FeCl_2 \cdot 4H_2O$ (mg) | Flux (mg) |
| Example 14 | $CaAl_{12}O_{19}{:}Fe(\beta\text{-alumina})$ | 0.23 | - | 1.59 | 8 | 59 |

| Item | Composition | Raw material composition | | | | |
|---|---|---|---|---|---|---|
| | | $SrCO_3$ (g) | $Na_2CO_3$ (g) | $Al_2O_3$ (g) | $FeCl_2 \cdot 4H_2O$ (mg) | Flux (mg) |
| Example 15 | $SrAl_{12}O_{19}{:}Fe(\beta\text{-alumina})$ | 0.34 | - | 1.59 | 8 | 59 |

## Description

## Technical Field

The present disclosure relates to a fluorescent body, a light source, and a biochemical analyzer using the light source.

## Background Art

In a biochemical analyzer, a reagent is added to a sample, light is emitted thereto, and a light emission intensity is measured, so as to observe a concentration of the biological sample. In the biochemical analyzer, a wavelength region of light with which the sample is irradiated is a wide wavelength region of 340 to 800 nm, and a light source that can emit light in this wavelength region is used.

In recent years, a light emitting diode (LED) that emits near-ultraviolet light has been developed and used as a light source for sample analysis. In the biochemical analyzer, the sample is analyzed by using the light in the wide wavelength region of 340 to 800 nm as described above, and in order to use the above LED, it is necessary to use a fluorescent body that is excited by the near-ultraviolet light and emits light in a near-infrared wavelength region.

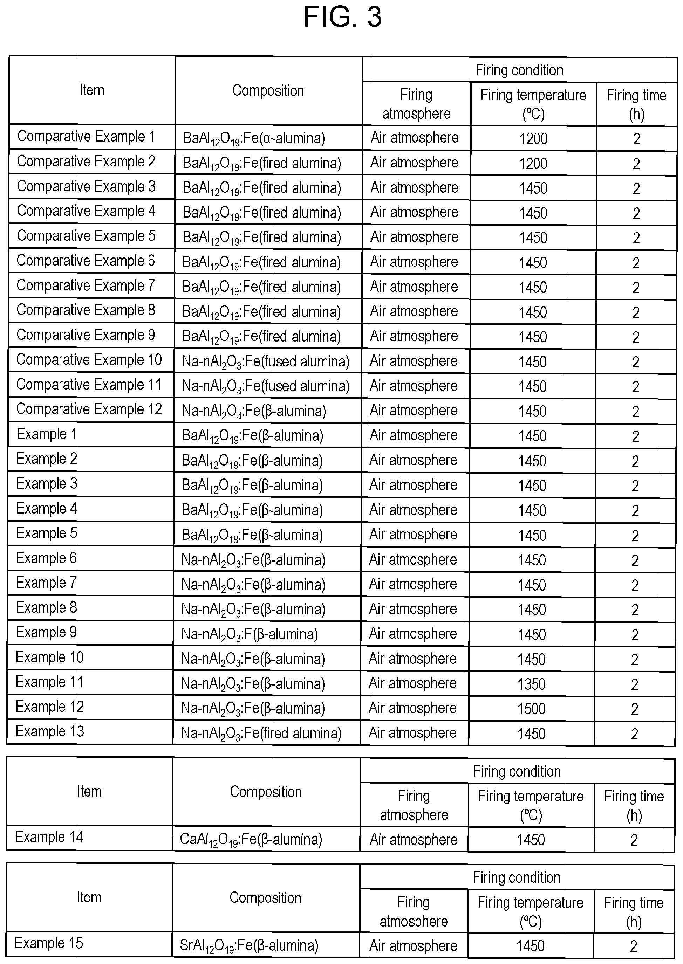

PTL 1 discloses a fluorescent body that is excited by a near-ultraviolet light emitting LED to cause near-infrared light emitting. Specifically, PTL 1 discloses, as an example of the above fluorescent body, $LiAlO_2$:Fe (peak wavelength in a light emitting spectrum: 746 nm) and $Al_2O_3$:Cr (emission wavelength is not described) that emit infrared light in a light emitting device (see abstract, paragraph 0066 and FIG 3).

In addition, PTL 2 discloses $LiGaO_2$:Fe as a fluorescent component that emits near-infrared light. Further, PTL 3 discloses, as a preferable example, a technique of using an ultraviolet-excited fluorescent body (BAM) having an average particle diameter of 5 $\mu$m or less in a light emitting device (see paragraph 0026). This fluorescent body emits visible light (see paragraph 0021 and Table 3).

Further, Non-PTL 1 discloses a crystal synthesis method for a fluorescent body by using $Al_2(SO_4)_3 \cdot 18H_2O$ as a raw material. Further, Non-PTL 2 discloses an example of synthesizing a fluorescent body by using a material in which metal Al is dissolved as a starting raw material. Further, Non-PTL 3 discloses an example of synthesizing a fluorescent body by using AlOOH or $Al(NO_3)_3 \cdot 9H_2O$ as a starting raw material.

## Citation List

## Patent Literature

PTL 1: JP-A-2001-352101
PTL 2: JP-A-2015-60921
PTL 3: JP-A-2016-103556

## Non-Patent Literature

Non-PTL 1: React. Kinet. Catal. Lett. Vol. 86, No. 2, 299-306 (2005)
Non-PTL 2: J. Electrochem. Soc. Vol. 147, No. 11, 4368-4373 (2000)
Non-PTL 3: Displays Vol. 19, 197-203 (1999)

## Summary of Invention

## Technical Problem

As the light source of the biochemical analyzer, instead of using a tungsten lamp having a short lamp life, a plurality of types of LED light sources having different wavelength regions may be used. However, when a plurality of types of LED light sources are used, a problem of luminance unevenness in a light emitting region rises.

$LiAlO_2$:Fe and $Al_2O_3$:Cr are known as near-infrared light-emitting fluorescent bodies. However, these fluorescent bodies do not have many excitation bands in a near-ultraviolet region (wavelength within a range of approximately 300 nm to 405 nm). Therefore, when a light source that combines the near-ultraviolet light emitting LED and the fluorescent body is used, there is a problem that a light emission intensity of near-infrared light emission is low. Therefore, it is necessary to search for a new near-infrared light-emitting fluorescent body in order to prepare a light source that can be combined with the LED that emits the near-ultraviolet light and that can be applied to a biochemical analyzer.

The disclosure has been made in view of the above problems, and provides a technique of improving the performance of an analyzer and facilitates the maintenance of the analyzer.

Solution to Problem

In order to solve above problems, a fluorescent body is provided, which is produced by firing a raw material containing an alumina, and at least one among Fe, Cr, Bi, Tl, Ce, Tb, Eu, and Mn, wherein the raw material contains 6.1 to 15.9 wt% of sodium with respect to a total amount of the raw material.

Further, as another example, a fluorescent body is provided, which has a peak of light emission intensity in a range of 760 to 790 nm, a quantum efficiency of 50% or more, and an absorptance of 25% or more.

The present description includes the disclosure content of Japanese Patent Application No. 2018-090854, which is the basis for the priority of the present application.

## Advantageous Effect

According to the disclosure, the performance of the analyzer can be improved and the maintenance of the analyzer can be facilitated. Problems, configurations, and effects other than those described above will be further clarified with the following description of embodiments.

## Brief Description of Drawings

[FIG. 1] FIG. 1 is a diagram showing a configuration of a light source for use in a biochemical analyzer according to the disclosure.

[FIG. 2] FIG. 2 is a table showing a raw material composition of fluorescent bodies according to Comparative Examples and Examples.

[FIG. 3] FIG. 3 is a table showing firing conditions of the fluorescent bodies according to Comparative Examples and Examples.

[FIG. 4] FIG. 4 is a table showing characteristics of the fluorescent bodies according to Comparative Examples and Examples.

[FIG. 5] FIG. 5 is a diagram showing an excitation spectrum of a near-infrared light-emitting fluorescent body according to the disclosure.

[FIG. 6] FIG. 6 is a diagram showing a light emitting spectrum when the near-infrared light-emitting fluorescent body is excited by near-ultraviolet light.

[FIG. 7] FIG. 7 is a diagram showing an excitation spectrum of the near-infrared light-emitting fluorescent body according to the disclosure.

[FIG. 8] FIG. 8 shows a light emitting spectrum of a light source according to Configuration Example 1.

## Description of Embodiments

Hereinafter, examples of the disclosure will be described with reference to the drawings. The examples of the disclosure are not limited to the examples to be described below, and various modifications can be made within the scope of the technical idea thereof. Corresponding parts of the drawings used in the description of each example to be described below are denoted by the same reference numerals, and a repetitive description will be omitted.

## <Configuration of Light Source for Use in Biochemical Analyzer>

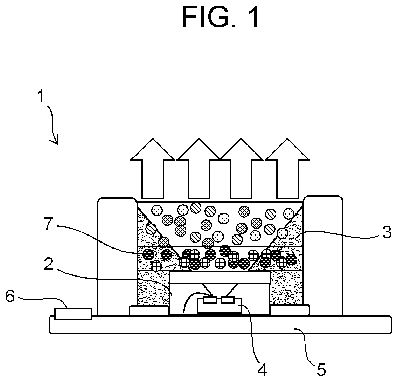

FIG. 1 is a diagram showing a configuration of a light source for use in a biochemical analyzer according to the disclosure. A light source 1 includes an LED module 2, a transparent resin 3, an LED element 4 (for example, the LED element includes a plurality of elements having different emission wavelengths), a heat sink 5, and a wiring 6. In addition, a plurality of types of fluorescent bodies 7 are mixed in the transparent resin 3. Here, the plurality of types of the fluorescent bodies 7 include the fluorescent body according to the disclosure described later.

Here, it is ideal to use one LED element in the LED module 2 from a viewpoint of preventing luminance unevenness. However, a configuration, in which the light emission power is improved by using a plurality of LED elements that emit light having a wavelength of 340 nm, may be used. Further, LED elements having different emission wavelengths, such as the LED element that emits light having a wavelength of 340 nm and an LED element that emits light having a wavelength of 405 nm, can be combined and incorporated into the LED module 2.

As the transparent resin 3, a silicone resin is mainly used when light to be transmitted is visible light. Further, when the light to be transmitted is near-ultraviolet light, a fluororesin or the like through which the near-ultraviolet light transmits can be used. These transparent resins can easily be mixed with the fluorescent body, and can be cured by firing at a temperature of about 250°C or lower.

The transparent resin 3 mixed with the fluorescent body 7 is directly placed above the LED element 4, or may be placed on a quartz glass or the like through which the near-ultraviolet light transmits and placed in a path of the emitted LED light. Further, by applying a silane coupling agent or the like on the LED element 4 or on the quartz glass before a resin layer is placed, adhesiveness of the resin layer can be improved.

The LED module 2 may be formed of the transparent resin in a single layer form, or may be formed in a multi-layer form in which a plurality of layers are stacked by changing the type of the fluorescent body to be mixed for each layer. Further, the transparent resin may contain light scattering material fine particles.

A reflective material (not shown) may be provided between the resin layer and a wall surface of the LED module 2. By providing the transparent resin mixed with the fluorescent body 7 in a light emitting region of the LED element 4 as described above, the LED light hits the fluorescent body 7, light having wavelengths of near-ultraviolet light to blue light is converted into light having wavelengths of visible light to near-infrared light, and the light emitted by the fluorescent body 7, together with the original LED light, is emitted from the light source 1.

Since the LED module 2, especially surroundings of the LED element 4, becomes hot, the heat sink 5 may be provided. Further, a cooling mechanism for water-cooling or air-cooling may be provided on a side of the heat sink opposite to the LED module 2. Efficiency with which the fluorescent body 7 absorbs and emits the light having the wavelengths of near-ultraviolet light to blue light tends to decrease when a temperature of the fluorescent body 7 rises. Therefore, it is desirable that the light source 1 is provided with the cooling mechanism as described above.

In the light source 1 having such a configuration, the fluorescent body is excited by the LED light (having the wavelengths of near-ultraviolet light to blue light), and the LED light and the light emitted from the fluorescent body whose wavelength is converted, as light in a wavelength region of 340 to 800 nm, are emitted from the light source 1. The biochemical analyzer to which the above light source 1 is applied can monitor absorption of light (amount of transmitted light) through a sample cell by using a light receiving device.

**<Synthesis of Near-infrared Light-emitting Fluorescent Body>**

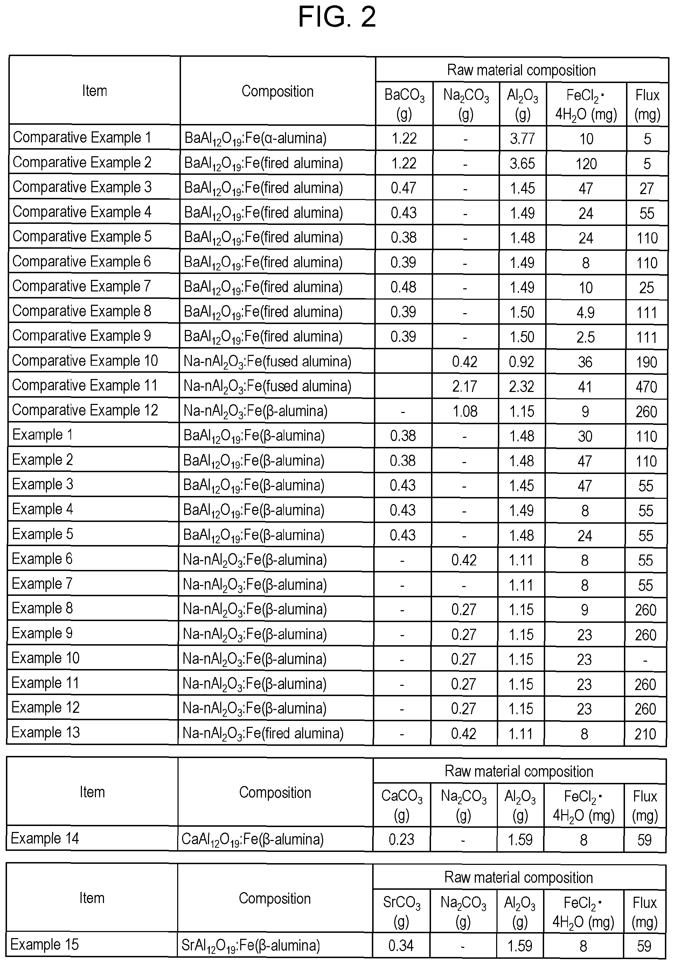

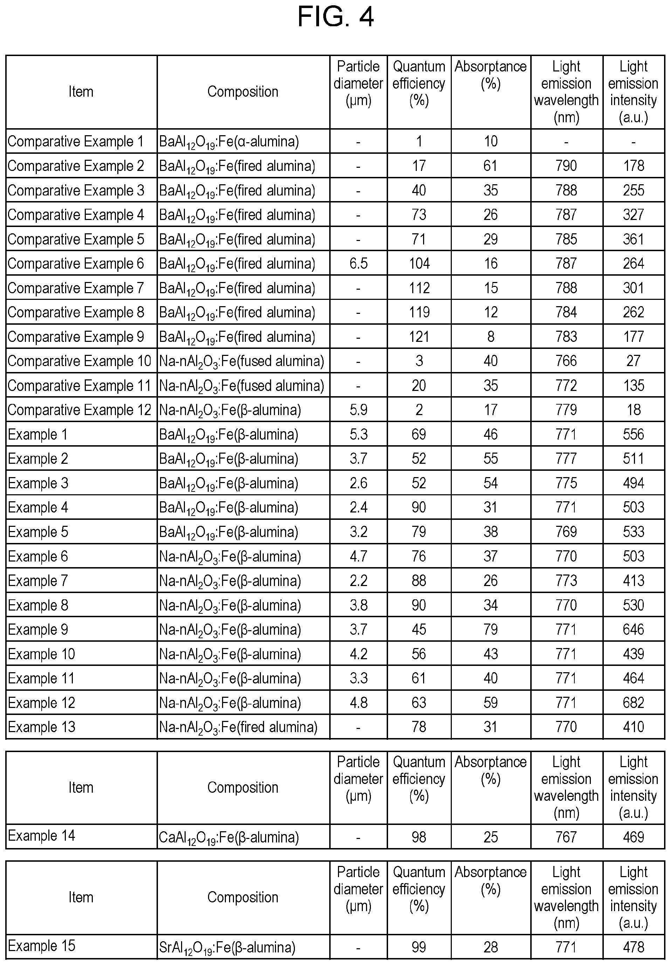

The near-infrared light-emitting fluorescent body was synthesized, and the synthesized fluorescent body was mixed in the transparent resin to prepare the light source for use in the biochemical analyzer. Hereinafter, Comparative Examples and Examples of the fluorescent body will be described with reference to FIGS. 2 to 4. FIG. 2 is a table showing a raw material composition of the fluorescent bodies according to Comparative Examples and Examples. FIG. 3 is a table showing firing conditions of the fluorescent bodies according to Comparative Examples and Examples. FIG. 4 is a table showing characteristics of the fluorescent bodies according to Comparative Examples and Examples.

**<Comparative Example 1>**

In Comparative Example 1, a fluorescent body was synthesized by using $\alpha$-alumina as a raw material. Raw materials for synthesizing the fluorescent body are 1.22 g of $BaCO_3$, 3.77 g of the $\alpha$-alumina, 10 mg of $FeCl_2 \cdot 4H_2O$, and 5 mg of a flux ($AlF_3$). These raw materials were mixed in a mortar, and the mixture was charged into an alumina crucible and fired at 1,200°C under air atmosphere for 2 hours. After firing and cooling, the fired fluorescent body was taken out and lightly crushed in the mortar to obtain a fluorescent body.

A target fluorescent body composition is $BaAl_{12}O_{19}$:Fe (a-alumina) (however, it is difficult to simply describe an exact composition ratio of $BaAl_{12}O_{19}$:Fe). $FeCl_2 \cdot 4H_2O$ used as the raw material has a bronze color because of $Fe^{2+}$, but when the raw materials are mixed in the mortar and allowed to stand for about 1 hour, $Fe^{2+}$ is oxidized in air and converted to $Fe^{3+}$ having a reddish brown color.

By using a quantum-yield measurement device, a quantum efficiency and an absorptance were measured when the fluorescent body according to Comparative Example 1 was excited by the light having a wavelength of 340 nm. As a result, the quantum efficiency was 1% and the absorptance was 10%. Therefore, when the fluorescent body was synthesized by using the $\alpha$-alumina as the raw material, almost no light emission of the fluorescent body could be confirmed.

**<Comparative Example 2>**

In Comparative Example 2, a fluorescent body was synthesized by using a fired alumina as a raw material. The fired alumina is a product (product name: S powder) produced by Shinkosha Co., Ltd, and is an alumina prepared by firing. Raw materials for synthesizing the fluorescent body are 1.22 g of $BaCO_3$, 3.65 g of the fired alumina, 120 mg of $FeCl_2 \cdot 4H_2O$, and 5 mg of a flux ($AlF_3$). These raw materials were mixed in a mortar, and the mixture was charged into an alumina crucible and fired at 1,200°C under air atmosphere for 2 hours.

By using the quantum-yield measurement device, a quantum efficiency and an absorptance were measured when the fluorescent body according to Comparative Example 2 was excited by the light having a wavelength of 340 nm. As a result, the quantum efficiency was 17%, the absorptance was 61%, and the light emission intensity was 178. The fluorescent body synthesized in Comparative Example 2 had a light emission peak at 790 nm. The light emission intensity is the intensity of light having a wavelength showing a light emission peak, and in the quantum-yield measurement device, the unit is Energy (a.u.).

**<Comparative Example 3>**

In Comparative Example 3, a fluorescent body was synthesized by using a fired alumina as a raw material. The fired alumina is a product produced by Shinkosha Co., Ltd, and is an alumina prepared by firing. Raw materials for synthesizing the fluorescent body are 0.47 g of $BaCO_3$, 1.45 g of the fired alumina, 47 mg of $FeCl_2 \cdot 4H_2O$, and 27 mg of a flux ($AlF_3$). These raw materials were mixed in a mortar, and the mixture was charged into an alumina crucible and fired at 1,450°C under air atmosphere for 2 hours.

By using the quantum-yield measurement device, a quantum efficiency and an absorptance were measured when the fluorescent body according to Comparative Example 3 was excited by the light having a wavelength of 340 nm. As a result, the quantum efficiency was 40%, the absorptance was 35%, and the light emission intensity was 255. The fluorescent body synthesized in Comparative Example 3 had a light emission peak at 788 nm.

**<Comparative Example 4>**

In Comparative Example 4, a fluorescent body was synthesized by using a fired alumina as a raw material. The fired alumina is a product produced by Shinkosha Co., Ltd, and is an alumina produced by firing. Raw materials for synthesizing the fluorescent body are 0.43 g of $BaCO_3$, 1.49 g of the fired alumina, 24 mg of $FeCl_2 \cdot 4H_2O$, and 55 mg of a flux ($AlF_3$). These raw materials were mixed in a mortar, and the mixture was charged into an alumina crucible and fired at 1,450°C under air atmosphere for 2 hours.

By using the quantum-yield measurement device, a quantum efficiency and an absorptance were measured when the fluorescent body according to Comparative Example 5 was excited by the light having a wavelength of 340 nm. As a result, the quantum efficiency was 73%, the absorptance was 26%, and the light emission intensity was 327. The fluorescent body synthesized in Comparative Example 4 had a light emission peak at 787 nm.

**<Comparative Example 5>**

In Comparative Example 5, a fluorescent body was synthesized by using a fired alumina as a raw material. The fired alumina is a product produced by Shinkosha Co., Ltd, and is an alumina produced by firing. Raw materials for synthesizing the fluorescent body are 0.38 g of $BaCO_3$, 1.48 g of the fired alumina, 24 mg of $FeCl_2 \cdot 4H_2O$, and 110 mg of a flux ($AlF_3$). These raw materials were mixed in a mortar, and the mixture was charged into an alumina crucible and fired at 1,450°C under air atmosphere for 2 hours.

By using the quantum-yield measurement device, a quantum efficiency and an absorptance were measured when the fluorescent body according to Comparative Example 5 was excited by the light having a wavelength of 340 nm. As a result, the quantum efficiency was 71%, the absorptance was 29%, and the light emission intensity was 361. The fluorescent body synthesized in Comparative Example 5 had a light emission peak at 785 nm.

**<Comparative Example 6>**

In Comparative Example 6, a fluorescent body was synthesized by using a fired alumina as a raw material. The fired alumina is a product produced by Shinkosha Co., Ltd, and is an alumina produced by firing. Raw materials for synthesizing the fluorescent body are 0.39 g of $BaCO_3$, 1.49 g of the fired alumina, 8 mg of $FeCl_2 \cdot 4H_2O$, and 110 mg of a flux ($AlF_3$). These raw materials were mixed in a mortar, and the mixture was charged into an alumina crucible and fired at 1,450°C under air atmosphere for 2 hours.

By using the quantum-yield measurement device, a quantum efficiency and an absorptance were measured when the fluorescent body according to Comparative Example 6 was excited by the light having a wavelength of 340 nm. As a result, the quantum efficiency was 104%, the absorptance was 16%, and the light emission intensity was 264. The fluorescent body synthesized in Comparative Example 6 had a light emission peak at 787 nm. Further, when a particle diameter of the fluorescent body was measured by a particle size distribution analyzer, the particle diameter (D50) of the fluorescent body was 6.5 $\mu$m.

**<Comparative Example 7>**

In Comparative Example 7, a fluorescent body was synthesized by using a fired alumina as a raw material. The fired alumina is a product produced by Shinkosha Co., Ltd, and is an alumina produced by firing. Raw materials for synthesizing the fluorescent body are 0.48 g of $BaCO_3$, 1.49 g of the fired alumina, 10 mg of $FeCl_2 \cdot 4H_2O$, and 25 mg of a flux ($AlF_3$). These raw materials were mixed in a mortar, and the mixture was charged into an alumina crucible and fired at 1,450°C under air atmosphere for 2 hours.

By using the quantum-yield measurement device, a quantum efficiency and an absorptance were measured when the fluorescent body according to Comparative Example 7 was excited by the light having a wavelength of 340 nm. As a result, the quantum efficiency was 112%, the absorptance was 15%, and the light emission intensity was 301. The fluorescent body synthesized in Comparative Example 7 had a light emission peak at 788 nm.

**<Comparative Example 8>**

In Comparative Example 8, a fluorescent body was synthesized by using a fired alumina as a raw material. The fired alumina is a product produced by Shinkosha Co., Ltd, and is an alumina produced by firing. Raw materials for synthesizing the fluorescent body are 0.39 g of $BaCO_3$, 1.50 g of the fired alumina, 4.9 mg of $FeCl_2 \cdot 4H_2O$, and 111 mg of a flux ($AlF_3$). These raw materials were mixed in a mortar, and the mixture was charged into an alumina crucible and fired at 1,450°C under air atmosphere for 2 hours.

By using the quantum-yield measurement device, a quantum efficiency and an absorptance were measured when the fluorescent body according to Comparative Example 8 was excited by the light having a wavelength of 340 nm. As a result, the quantum efficiency was 119%, the absorptance was 12%, and the light emission intensity was 262. The fluorescent body synthesized in Comparative Example 8 had a light emission peak at 784 nm.

**<Comparative Example 9>**

In Comparative Example 9, a fluorescent body was synthesized by using a fired alumina as a raw material. The fired alumina is a product produced by Shinkosha Co., Ltd, and is an alumina produced by firing. Raw materials for synthesizing the fluorescent body are 0.39 g of $BaCO_3$, 1.50 g of the fired alumina, 2.5 mg of $FeCl_2 \cdot 4H_2O$, and 111 mg of a flux ($AlF_3$). These raw materials were mixed in a mortar, and the mixture was charged into an alumina crucible and fired at 1,450°C under air atmosphere for 2 hours.

By using the quantum-yield measurement device, a quantum efficiency and an absorptance were measured when the fluorescent body according to Comparative Example 9 was excited by the light having a wavelength of 340 nm. As a result, the quantum efficiency was 121%, the absorptance was 8%, and the light emission intensity was 177. The fluorescent body synthesized in Comparative Example 9 had a light emission peak at 783 nm.

In Comparative Examples 2 to 9, the fired alumina was used as the alumina raw material. In Comparative Examples 2 to 9, an addition amount of Fe was mainly adjusted. As the addition amount of Fe became smaller, the quantum efficiency was improved, and the absorptance was decreased.

**<Comparative Example 10>**

In Comparative Example 10, a fluorescent body was synthesized by using a fused alumina as a raw material. The fused alumina is a product of Pure Chemical Co., Ltd. Raw materials for synthesizing the fluorescent body are 0.42 g of $Na_2CO_3$, 0.92 g of the fused alumina, 36 mg of $FeCl_2 \cdot 4H_2O$, and 190 mg of a flux ($BaCl_2$). These raw materials were mixed in a mortar, and the mixture was charged into an alumina crucible and fired at 1,450°C under air atmosphere for 2 hours.

By using the quantum-yield measurement device, a quantum efficiency and an absorptance were measured when the fluorescent body according to Comparative Example 10 was excited by the light having a wavelength of 340 nm. As a result, the quantum efficiency was 3%, the absorptance was 40%, and the light emission intensity was 27. The fluorescent body synthesized in Comparative Example 10 had a light emission peak at 766 nm. When the fused alumina was used as the raw material, the light emission could be confirmed, but the light emission intensity was low. The fused alumina contains a small amount of the $\beta$-alumina, and the amount thereof is extremely small, about 1%.

**<Comparative Example 11>**

In Comparative Example 11, a fluorescent body was synthesized by using a fused alumina as a raw material. The fused alumina is a product of Pure Chemical Co., Ltd. Raw materials for synthesizing the fluorescent body are 2.17 g of $Na_2CO_3$, 2.32 g of the fused alumina, 41 mg of $FeCl_2 \cdot 4H_2O$, and 470 mg of a flux ($BaCl_2$).

These raw materials were mixed in a mortar, and the mixture was charged into an alumina crucible and fired at 1,450°C under air atmosphere for 2 hours.

By using the quantum-yield measurement device, a quantum efficiency and an absorptance were measured when the fluorescent body according to Comparative Example 11 was excited by the light having a wavelength of 340 nm. As a result, the quantum efficiency was 20%, the absorptance was 35%, and the light emission intensity was 135. The fluorescent body synthesized in Comparative Example 11 had a light emission peak at 772 nm. It was confirmed that the emitted light amount could be increased by increasing the amount of Na even when the fused alumina was used.

**<Comparative Example 12>**

In Comparative Example 12, a fluorescent body was synthesized by using $\beta$-alumina as a raw material in order to obtain Na-$nAl_2O_3$:Fe. The $\beta$-alumina to be used had a shape of Powder ca. 3 $\mu$m and was obtained from Kojundo Chemical Lab. Co, Ltd.

Raw materials for synthesizing the fluorescent body are 1.08 g of $Na_2CO_3$, 1.15 g of the $\beta$-alumina (mixed phase product), 9 mg of $FeCl_2 \cdot 4H_2O$, and 260 mg of a flux ($BaCl_2$). These raw materials were mixed in a mortar, and the mixture was charged into an alumina crucible and fired at a firing temperature of 1,450°C under air atmosphere for 2 hours.

By using the quantum-yield measurement device, a quantum efficiency and an absorptance were measured when the fluorescent body according to Comparative Example 12 was excited by the light having a wavelength of 340 nm. As a result, the quantum efficiency was 2%, the absorptance was 17%, and the light emission intensity was 18. The fluorescent body synthesized in Comparative Example 12 had a light emission peak at 779 nm. Further, when a particle diameter of the fluorescent body was measured by a particle size distribution analyzer, the particle diameter (D50) of the fluorescent body was 5.9 $\mu$m.

**<Example 1>**

In Example 1, a fluorescent body was synthesized by using $\beta$-alumina as a raw material. The $\beta$-alumina is a mixed phase product (sintered product) of $NaAl_{11}O_{17}$ ($\beta$ phase) and $NaAl_5O_8$ ($\beta''$ phase) and containing Na in the alumina raw material. Here, the $\beta$ phase and the $\beta''$ phase are collectively referred to as the $\beta$-alumina (or $\beta$-$Al_2O_3$). Here, in the present description, "$\beta$-alumina" means a substance containing 50% or more of a $\beta$-alumina component and having the $\beta$-alumina as a main component. The $\beta$-alumina to be used had a shape of Powder ca. 3 $\mu$m and was obtained from Kojundo Chemical Lab. Co., Ltd. According to X-ray analysis, the $\beta$-alumina was confirmed to have different phases, which were considered to be $\alpha$-alumina and $\gamma$-alumi-

na, but contained 90% or more of β-alumina. Further, the β-alumina contained 6.5 wt% of Na.

Raw materials for synthesizing the fluorescent body are 0.38 g of $BaCO_3$, 1.48 g of the β-alumina (mixed phase product), 30 mg of $FeCl_2 \cdot 4H_2O$, and 110 mg of a flux ($BaCl_2$). These raw materials were mixed in a mortar, and the mixture was charged into an alumina crucible and fired at a firing temperature of 1,450°C under air atmosphere for 2 hours.

By using the quantum-yield measurement device, a quantum efficiency and an absorptance were measured when the fluorescent body according to Example 1 was excited by the light having a wavelength of 340 nm. As a result, the quantum efficiency was 69%, the absorptance was 46%, and the light emission intensity was 556. The fluorescent body synthesized in Example 1 had a light emission peak at 771 nm. Further, when a particle diameter of the fluorescent body was measured by the particle size distribution analyzer, the particle diameter (D50) of the fluorescent body was 5.3 μm. The fluorescent body according to Example 1 had substantially the same amount of the raw material as that in Comparative Example 5, but the light emission intensity was higher than that in the case of using the fired alumina (light emission intensity 361).

**<Example 2>**

In Example 2, a fluorescent body was synthesized by using β-alumina as a raw material. The β-alumina to be used had a shape of Powder ca. 3 μm and was obtained from Kojundo Chemical Lab. Co., Ltd.

Raw materials for synthesizing the fluorescent body are 0.38 g of $BaCO_3$, 1.48 g of the β-alumina (mixed phase product), 47 mg of $FeCl_2 \cdot 4H_2O$, and 110 mg of a flux ($BaCl_2$). These raw materials were mixed in a mortar, and the mixture was charged into an alumina crucible and fired at a firing temperature of 1,450°C under air atmosphere for 2 hours.

By using the quantum-yield measurement device, a quantum efficiency and an absorptance were measured when the fluorescent body according to Example 2 was excited by the light having a wavelength of 340 nm. As a result, the quantum efficiency was 52%, the absorptance was 55%, and the light emission intensity was 511. The fluorescent body synthesized in Example 2 had a light emission peak at 777 nm. Further, when a particle diameter of the fluorescent body was measured by the particle size distribution analyzer, the particle diameter (D50) of the fluorescent body was 3.7 μm.

**<Example 3>**

In Example 2, a fluorescent body was synthesized by using β-alumina as a raw material. The β-alumina to be used had a shape of Powder ca. 3 μm and was obtained from Kojundo Chemical Lab. Co, Ltd.

Raw materials for synthesizing the fluorescent body are 0.43 g of $BaCO_3$, 1.45 g of the β-alumina (mixed phase product), 47 mg of $FeCl_2 \cdot 4H_2O$, and 55 mg of a flux ($BaCl_2$). These raw materials were mixed in a mortar, and the mixture was charged into an alumina crucible and fired at a firing temperature of 1,450°C under air atmosphere for 2 hours.

By using the quantum-yield measurement device, a quantum efficiency and an absorptance were measured when the fluorescent body according to Example 3 was excited by the light having a wavelength of 340 nm. As a result, the quantum efficiency was 52%, the absorptance was 54%, and the light emission intensity was 494. The fluorescent body synthesized in Example 3 had a light emission peak at 775 nm. Further, when a particle diameter of the fluorescent body was measured by the particle size distribution analyzer, the particle diameter (D50) of the fluorescent body was 2.6 μm.

**<Example 4>**

In Example 4, a fluorescent body was synthesized by using β-alumina as a raw material. The β-alumina to be used had a shape of Powder ca. 3 μm and was obtained from Kojundo Chemical Lab. Co. Ltd.

Raw materials for synthesizing the fluorescent body are 0.43 g of $BaCO_3$, 1.49 g of the β-alumina (mixed phase product), 8 mg of $FeCl_2 \cdot 4H_2O$, and 55 mg of a flux ($BaCl_2$). These raw materials were mixed in a mortar, and the mixture was charged into an alumina crucible and fired at a firing temperature of 1,450°C under air atmosphere for 2 hours.

By using the quantum-yield measurement device, a quantum efficiency and an absorptance were measured when the fluorescent body according to Example 4 was excited by the light having a wavelength of 340 nm. As a result, the quantum efficiency was 90%, the absorptance was 31%, and the light emission intensity was 503. The fluorescent body synthesized in Example 4 had a light emission peak at 771 nm. Further, when a particle diameter of the fluorescent body was measured by the particle size distribution analyzer, the particle diameter (D50) of the fluorescent body was 2.4 μm.

**<Example 5>**

In Example 5, a fluorescent body was synthesized by using β-alumina as a raw material. The β-alumina to be used had a shape of Powder ca. 3 μm and was obtained from Kojundo Chemical Lab. Co., Ltd.

Raw materials for synthesizing the fluorescent body are 0.43 g of $BaCO_3$, 1.48 g of the β-alumina (mixed phase product), 24 mg of $FeCl_2 \cdot 4H_2O$, and 55 mg of a flux ($BaCl_2$). These raw materials were mixed in a mortar, and the mixture was charged into an alumina crucible and fired at a firing temperature of 1,450°C under air atmosphere for 2 hours.

By using the quantum-yield measurement device, a quantum efficiency and an absorptance were measured when the fluorescent body according to Example 5 was excited by the light having a wavelength of 340 nm. As a result, the quantum efficiency was 79%, the absorptance was 38%, and the light emission intensity was 533. The fluorescent body synthesized in Example 5 had a light emission peak at 769 nm. Further, when a particle diameter of the fluorescent body was measured by the particle size distribution analyzer, the particle diameter (D50) of the fluorescent body was 3.2 $\mu$m.

**<Example 6>**

In Example 6, a fluorescent body was synthesized by using $\beta$-alumina as a raw material to obtain Na-nAl$_2$O$_3$:Fe. The $\beta$-alumina to be used had a shape of Powder ca. 3 $\mu$m and was obtained from Kojundo Chemical Lab. Co., Ltd.

Raw materials for synthesizing the fluorescent body are 0.42 g of Na$_2$CO$_3$, 1.11 g of the $\beta$-alumina (mixed phase product), 8 mg of FeCl$_2$·4H$_2$O, and 55 mg of a flux (BaCl$_2$). These raw materials were mixed in a mortar, and the mixture was charged into an alumina crucible and fired at a firing temperature of 1,450°C under air atmosphere for 2 hours.

By using the quantum-yield measurement device, a quantum efficiency and an absorptance were measured when the fluorescent body according to Example 6 was excited by the light having a wavelength of 340 nm. As a result, the quantum efficiency was 76%, the absorptance was 37%, and the light emission intensity was 503. The fluorescent body synthesized in Example 6 had a light emission peak at 770 nm. Further, when a particle diameter of the fluorescent body was measured with the particle size distribution analyzer, the particle diameter (D50) of the fluorescent body was 4.7 $\mu$m.

**<Example 7>**

In Example 7, a fluorescent body was synthesized by using $\beta$-alumina as a raw material to obtain Na-nAl$_2$O$_3$:Fe. The $\beta$-alumina to be used had a shape of Powder ca. 3 $\mu$m and was obtained from Kojundo Chemical Lab. Co., Ltd.

Raw materials for synthesizing the fluorescent body are 1.11 g of the $\beta$-alumina (mixed phase product), 8 mg of FeCl$_2$·4H$_2$O, and 55 mg of a flux (BaCl$_2$). These raw materials were mixed in a mortar, and the mixture was charged into an alumina crucible and fired at a firing temperature of 1,450°C under air atmosphere for 2 hours. In Example 7, Na$_2$CO$_3$ was not contained in the raw material.

By using the quantum-yield measurement device, a quantum efficiency and an absorptance were measured when the fluorescent body according to Example 7 was excited by the light having a wavelength of 340 nm. As a result, the quantum efficiency was 88%, the absorptance was 26%, and the light emission intensity was 413. The fluorescent body synthesized in Example 7 had a light emission peak at 773 nm. Further, when a particle diameter of the fluorescent body was measured by the particle size distribution analyzer, the particle diameter (D50) of the fluorescent body was 2.2 $\mu$m.

**<Example 8>**

In Example 8, a fluorescent body was synthesized by using $\beta$-alumina as a raw material to obtain Na-nAl$_2$O$_3$:Fe. The $\beta$-alumina to be used had a shape of Powder ca. 3 $\mu$m and was obtained from Kojundo Chemical Lab. Co., Ltd.

Raw materials for synthesizing the fluorescent body are 0.27 g of Na$_2$CO$_3$, 1.15 g of the $\beta$-alumina (mixed phase product), 9 mg of FeCl$_2$·4H$_2$O, and 260 mg of a flux (BaCl$_2$). These raw materials were mixed in a mortar, and the mixture was charged into an alumina crucible and fired at a firing temperature of 1,450°C under air atmosphere for 2 hours.

By using the quantum-yield measurement device, a quantum efficiency and an absorptance were measured when the fluorescent body according to Example 8 was excited by the light having a wavelength of 340 nm. As a result, the quantum efficiency was 90%, the absorptance was 34%, and the light emission intensity was 530. The fluorescent body synthesized in Example 8 had a light emission peak at 770 nm. Further, when a particle diameter of the fluorescent body was measured by the particle size distribution analyzer, the particle diameter (D50) of the fluorescent body was 3.8 $\mu$m.

**<Example 9>**

In Example 9, a fluorescent body was synthesized by using $\beta$-alumina as a raw material to obtain Na-nAl$_2$O$_3$:Fe. The $\beta$-alumina to be used had a shape of Powder ca. 3 $\mu$m and was obtained from Kojundo Chemical Lab. Co., Ltd.

Raw materials for synthesizing the fluorescent body are 0.27 g of Na$_2$CO$_3$, 1.15 g of the $\beta$-alumina (mixed phase product), 23 mg of FeCl$_2$·4H$_2$O, and 260 mg of a flux (BaCl$_2$). These raw materials were mixed in a mortar, and the mixture was charged into an alumina crucible and fired at a firing temperature of 1,450°C under air atmosphere for 2 hours.

By using the quantum-yield measurement device, a quantum efficiency and an absorptance were measured when the fluorescent body according to Example 9 was excited by the light having a wavelength of 340 nm. As a result, the quantum efficiency was 45%, the absorptance was 79%, and the light emission intensity was 646. The fluorescent body synthesized in Example 9 had a light emission peak at 771 nm. Further, when a particle diameter of the fluorescent body was measured by the particle size distribution analyzer, the particle diameter (D50) of the fluorescent body was 3.7 $\mu$m.

### <Example 10>

In Example 10, a fluorescent body was synthesized by using $\beta$-alumina as a raw material to obtain Na-nAl$_2$O$_3$:Fe. The $\beta$-alumina to be used had a shape of Powder ca. 3 $\mu$m and was obtained from Kojundo Chemical Lab. Co., Ltd.

Raw materials for synthesizing the fluorescent body are 0.27 g of Na$_2$CO$_3$, 1.15 g of the $\beta$-alumina (mixed phase product), and 23 mg of FeCl$_2$·4H$_2$O. These raw materials were mixed in a mortar, and the mixture was charged into an alumina crucible and fired at a firing temperature of 1,450°C under air atmosphere for 2 hours. In Example 10, the flux was not mixed in the raw material.

By using the quantum-yield measurement device, a quantum efficiency and an absorptance were measured when the fluorescent body according to Example 10 was excited by the light having a wavelength of 340 nm. As a result, the quantum efficiency was 56%, the absorptance was 43%, and the light emission intensity was 439. The fluorescent body synthesized in Example 10 had a light emission peak at 771 nm. Further, when a particle diameter of the fluorescent body was measured by the particle size distribution analyzer, the particle diameter (D50) of the fluorescent body was 4.2 $\mu$m.

### <Example 11>

In Example 11, a fluorescent body was synthesized by using $\beta$-alumina as a raw material to obtain Na-nAl$_2$O$_3$:Fe. The $\beta$-alumina to be used had a shape of Powder ca. 3 $\mu$m and was obtained from Kojundo Chemical Lab. Co., Ltd.

Raw materials for synthesizing the fluorescent body are 0.27 g of Na$_2$CO$_3$, 1.15 g of the $\beta$-alumina (mixed phase product), 23 mg of FeCl$_2$·4H$_2$O, and 260 mg of a flux (BaCl$_2$). These raw materials were mixed in a mortar, and the mixture was charged into an alumina crucible and fired at a firing temperature of 1,350°C under air atmosphere for 2 hours.

By using the quantum-yield measurement device, a quantum efficiency and an absorptance were measured when the fluorescent body according to Example 11 was excited by the light having a wavelength of 340 nm. As a result, the quantum efficiency was 61%, the absorptance was 40%, and the light emission intensity was 464. The fluorescent body synthesized in Example 11 had a light emission peak at 771 nm. Further, when a particle diameter of the fluorescent body was measured with the particle size distribution analyzer, the particle diameter (D50) of the fluorescent body was 3.3 $\mu$m.

### <Example 12>

In Example 12, a fluorescent body was synthesized by using $\beta$-alumina as a raw material to obtain Na-nAl$_2$O$_3$:Fe. The $\beta$-alumina to be used had a shape of Powder ca. 3 $\mu$m and was obtained from Kojundo Chemical Lab. Co., Ltd.

Raw materials for synthesizing the fluorescent body are 0.27 g of Na$_2$CO$_3$, 1.15 g of the $\beta$-alumina (mixed phase product), 23 mg of FeCl$_2$·4H$_2$O, and 260 mg of a flux (BaCl$_2$). These raw materials were mixed in a mortar, and the mixture was charged into an alumina crucible and fired at a firing temperature of 1,500°C under air atmosphere for 2 hours.

By using the quantum-yield measurement device, a quantum efficiency and an absorptance were measured when the fluorescent body according to Example 12 was excited by the light having a wavelength of 340 nm. As a result, the quantum efficiency was 63%, the absorptance was 59%, and the light emission intensity was 682. The fluorescent body synthesized in Example 12 had a light emission peak at 771 nm. Further, when a particle diameter of the fluorescent body was measured by the particle size distribution analyzer, the particle diameter (D50) of the fluorescent body was 4.8 $\mu$m. As can be seen from comparison with Example 11, as the firing temperature became higher, the light emission intensity increased and became better.

### <Example 13>

In Example 13, a fluorescent body was synthesized by using a fired alumina as a raw material. The fired alumina is a product produced by Shinkosha Co., Ltd, and is an alumina produced by firing. In Example 13, unlike Comparative Examples 2 to 9, Na$_2$CO$_3$ was contained in the raw material instead of BaCO$_3$. Further, Na-Br was used as the flux. A target fluorescent body composition is Na-nAl$_2$O$_3$:Fe (described as Na$_2$O-n'Al$_2$O$_3$, but in the present description, since Na$_2$CO$_3$ was added as a raw material, it is described as Na-nAl$_2$O$_3$:Fe).

Raw materials for synthesizing the fluorescent body are 0.42 g of Na$_2$CO$_3$, 1.11 g of the fired alumina, 8 mg of FeCl$_2$·4H$_2$O, and 210 mg of a flux (NaBr). These raw materials were mixed in a mortar, and the mixture was charged into an alumina crucible and fired at a firing temperature of 1,450°C under air atmosphere for 2 hours.

By using the quantum-yield measurement device, a quantum efficiency and an absorptance were measured when the fluorescent body according to Example 13 was excited by the light having a wavelength of 340 nm. As a result, the quantum efficiency was 78%, the absorptance was 31%, and the light emission intensity was 410. The fluorescent body synthesized in Example 13 had a light emission peak at 770 nm.

**<Example 14>**

In Example 14, a fluorescent body was synthesized by using β-alumina as a raw material to obtain $CaAl_{12}O_{19}$:Fe. The β-alumina to be used had a shape of Powder ca. 3 μm and was obtained from Kojundo Chemical Lab. Co. Ltd.

Raw materials for synthesizing the fluorescent body are 0.23 g of $CaCO_3$, 1.59 g of the β-alumina (mixed phase product), 8 mg of $FeCl_2 \cdot 4H_2O$, and 59 mg of a flux ($BaCl_2$). These raw materials were mixed in a mortar, and the mixture was charged into an alumina crucible and fired at a firing temperature of 1,450°C under air atmosphere for 2 hours.

By using the quantum-yield measurement device, a quantum efficiency and an absorptance were measured when the fluorescent body according to Example 14 was excited by the light having a wavelength of 340 nm. As a result, the quantum efficiency was 98%, the absorptance was 25%, and the light emission intensity was 469. The fluorescent body synthesized in Example 14 had a light emission peak at 767 nm.

**<Example 15>**

In Example 15, a fluorescent body was synthesized by using β-alumina as a raw material to obtain $SrAl_{12}O_{19}$:Fe. The β-alumina to be used had a shape of Powder ca. 3 μm and was obtained from Kojundo Chemical Lab. Co. Ltd.

Raw materials for synthesizing the fluorescent body are 0.34 g of $SrCO_3$, 1.59 g of the β-alumina (mixed phase product), 8 mg of $FeCl_2 \cdot 4H_2O$, and 59 mg of a flux ($BaCl_2$). These raw materials were mixed in a mortar, and the mixture was charged into an alumina crucible and fired at a firing temperature of 1,450°C under air atmosphere for 2 hours.

By using the quantum-yield measurement device, a quantum efficiency and an absorptance were measured when the fluorescent body according to Example 15 was excited by the light having a wavelength of 340 nm. As a result, the quantum efficiency was 99%, the absorptance was 28%, and the light emission intensity was 478. The fluorescent body synthesized in Example 15 had a light emission peak at 771 nm.

**[Result]**

As described above, when the fluorescent body is prepared by containing in the raw material 50% or more of the β-alumina, good results are obtained in the quantum efficiency, the absorptance, and the light emission intensity. Further, when Comparative Example 10 is compared with Comparative Example 11, it can be understood that even when the fluorescent body is prepared by using the fused alumina as the raw material, the quantum efficiency, the absorptance, and the light emission intensity are improved by containing a large amount of Na. For example, in Example 13, the fluorescent body is prepared by using the fired alumina as the raw material, but by adding a large amount of $Na_2CO_3$, high quantum efficiency, absorptance and light emission intensity are shown. On the other hand, as can be seen from the experimental results of Comparative Example 12, even when the fluorescent body is prepared by using the β-alumina as the raw material, when Na is added excessively, the particle diameter of the fluorescent body becomes too large, and desired quantum efficiency, absorptance, and light emission intensity cannot be obtained. For example, it is desirable that the total raw material contains 6.1 to 15.9 wt% of Na. The β-alumina used in Examples 1 to 12, 14, 15 and Comparative Example 12 this time contains 6.0 to 7.0 wt% of Na. Further, as can be seen from the experimental results of Examples 11 and 12, as a temperature at which the raw materials of the fluorescent body are fired increases, the absorptance and the light emission intensity are improved. The temperature at which the raw materials of the fluorescent body are fired is, for example, 1,300°C or higher, and preferably 1,500°C or higher. An average particle diameter (a value in which volume% is 50%) of the fluorescent bodies prepared in Examples 1 to 12 is 5.3 μm or less. $AlF_3$ or NaBr can be used as the flux, but since a degree of sintering of the fluorescent body is rather large, it is possible to control the particle diameter of the fluorescent body to be smaller by using $BaCl_2$. Further, as an activator, for example, at least one of Fe, Cr, Bi, Tl, Ce, Tb, Eu, and Mn or a combination thereof may be added.

**[Excitation Spectrum and Light Emitting Spectrum of Near-infrared Light-emitting Fluorescent Body]**

Next, an excitation spectrum and a light emitting spectrum of the disclosure will be described.

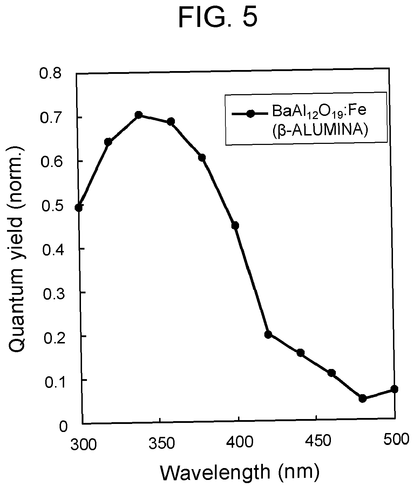

FIG. 5 is a diagram showing an excitation spectrum of the near-infrared light-emitting fluorescent body ($BaAl_{12}O_{19}$:Fe) according to the disclosure. An excitation band of $BaAl_{12}O_{19}$:Fe is in a range of 300 to 400 nm, and in particular, a peak in the excitation band is at 340 nm. Therefore, $BaAl_{12}O_{19}$:Fe is suitable for being excited by an LED that emits light having a wavelength of 340 nm.

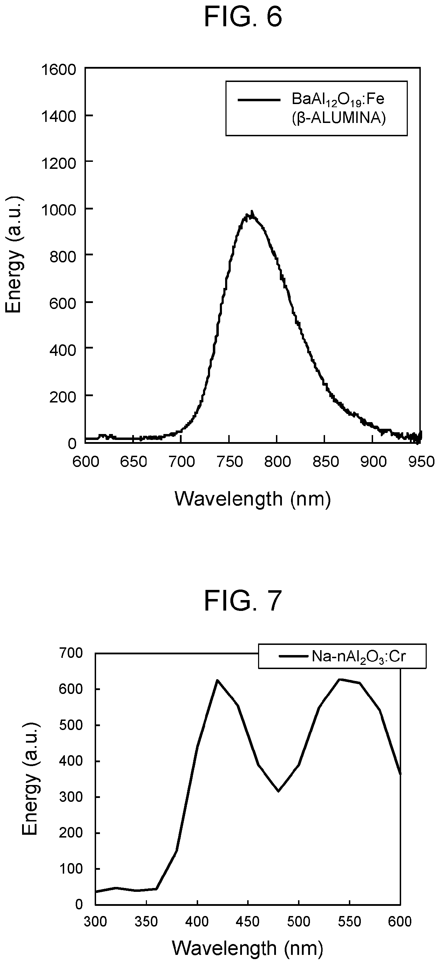

FIG. 6 is a diagram showing a light emitting spectrum when the fluorescent body ($BaAl_{12}O_{19}$:Fe) is excited by near-ultraviolet light having a wavelength of 340 nm. The fluorescent body ($BaAl_{12}O_{19}$:Fe) according to the disclosure has a light emission peak wavelength around 774 nm, a full width at half maximum of 86 nm, and a sufficiently high light emission intensity at a wavelength of 800 nm. That is, the fluorescent body ($BaAl_{12}O_{19}$:Fe) according to the disclosure has a light emitting component at a wavelength side longer than 750 nm. The full width at half maximum is 50 nm or more.

In contrast, a known fluorescent body ($LiAlO_2$:Fe) has a light emission peak wavelength of 750 nm or less. Further, $Al_2O_3$:Cr has a sharp light emitting spectrum with a narrow full width at half maximum. As described above, in the biochemical analyzer, analysis is performed by using 12 kinds of light having specific wavelengths between 340 nm and 800 nm. Therefore, it is necessary to use a fluorescent body having sufficient wide full widths at half maximum to cover these wavelengths, and having a sufficient light emission intensity in near-infrared light having a wavelength of 800 nm. It is difficult for known fluorescent bodies to meet the above requirements.

FIG. 7 is a diagram showing an excitation spectrum of the near-infrared light-emitting fluorescent body $(Na-nAl_2O_3:Cr (\beta-alumina))$ according to the disclosure. While a peak wavelength in an excitation spectrum of a Cr-activated fluorescent body having a Ga-based matrix composition is around 460 nm, a peak wavelength in the excitation spectrum of the near-infrared light-emitting fluorescent body $(Na-nAl_2O_3:Cr (\beta-alumina))$ according to the disclosure is around 420 nm. Therefore, the near-infrared light-emitting fluorescent body $(Na-nAl_2O_3:Cr (\beta-alumina))$ according to the disclosure is suitable for being excited by an LED element that emits light having a wavelength of 405 nm. The above characteristics are excitation band characteristics based on a combination of the $\beta$-alumina and a Cr light emission center.

When a light source is prepared by combining the LED element that emits the light having a wavelength of 405 nm and the LED element that emits the light having a wavelength of 340 nm, since the light emission intensity of the light having a wavelength of 405 nm is high, it is considered to use, as the near-infrared light-emitting fluorescent body, a Cr-activated Al-based fluorescent body or an Al,Ga-based fluorescent body that has a full width at half maximum in the light emitting spectrum wider than that of $Na-nAl_2O_3:Cr (\beta-alumina)$. $Y_3(Al,Ga)_5O_{12}:Cr$ can be mentioned as an example of such a fluorescent body.

In addition to Fe and Cr, it is effective to add Bi, Tl, Ce, Tb, Eu or Mn to the raw material as an additional element. These elements may be added separately, and a plurality of kinds such as Ce and Fe, or Eu and Cr may be combined and added to the raw material. These elements not only serve as light emission centers, but also form trap levels in the fluorescent body and contribute to light emission.

**[Material of Fluorescent Body for Use in Light Source]**

In order to emit light having a wavelength of 340 to 800 nm from the light source, in addition to the near-infrared light-emitting fluorescent body, it is effective to use a near-ultraviolet light-emitting fluorescent body, a blue light-emitting fluorescent body, a green light-emitting fluorescent body, an infrared light-emitting fluorescent body, and the like.

For example, a $Y_2SiO_5:Ce$ (P47) fluorescent body can be used as the near-ultraviolet light-emitting fluorescent body, a $BaMgAl_{10}O_{17}:Eu$ (BAM) fluorescent body (340 nm excitation) or an $(Sr,Ca,Ba)_{10}(PO_4)_6Cl_2:Eu$ (SCA) fluorescent body (405 nm excitation) can be used as the blue light-emitting fluorescent body, an $(Sr,Ba,Mg)_2SiO_4:Eu$ (BOS) fluorescent body can be used as the green light-emitting fluorescent body, and a $CaAlSiN_3:Eu$ (CASN) fluorescent body can be used as the infrared light-emitting fluorescent body.

Examples of the fluorescent body that emits blue light when being excited by the near-ultraviolet light include $Sr_5(PO_4)_3Cl:$ Eu, $Ba_5SiO_4Cl_6:Eu$, $(Sr,Ba)Al_2Si_2O_8:$ Eu, $BaMg_2Al_{16}O_{27}:Eu$, $Sr_4Al_{14}O_{25}:Eu$, $Sr_2P_2O_7:Eu$, $Sr_3(PO_4)_2:Eu$, $LiSrPO_4:Eu$, $Ba_3MgSi_2O_8:Eu$, $BaAl_2S_4:Eu$, $CF_2:Eu$, $AlN:Eu$, $BaSi_2O_2N_2:Eu$, $YBO_3:Ce$, $Sr_3(BO_3)_2:Ce$, $LaAl(Si,Al)_6(N,O)_{10}:Ce$, $Y_2O_3:Bi$, $GaN:Zn$, $ZnS:Ag,Cl$, and $ZnS:Ag,Br$.

Examples of the fluorescent body that emits green light when being excited by the near-ultraviolet light include $Sr_2SiO_4:Eu$, $Ba_2SiO_4:Eu$, $SrAl_2O_4:Eu$, $CaAl_2S_4:Eu$, $SrAl_2S_4:Eu$, $CaGa_2S_4:Eu$, $SrGa_2S_4:Eu$, $\beta$-SiAlON:Eu, $CaSi_2O_2N_2:Eu$, $SrSi_2O_2N_2:Eu$, $Ba_3Si_6O_{12}N_2:Eu$, $\alpha$-SiAlON:Yb, $BaMgAl_{10}O_{17}:Eu,Mn$, $Zn_2GeO_4:Mn$, $ZnS:Cu,Al$, $ZnO:Zn$, $LiTbW_2O_8$, $NaTbW_2O_8$, and $KTbW_2O_8$.

Examples of the fluorescent body that emits yellow light and orange light when being excited by the near-ultraviolet light include $Ca_3SiO_5:Eu$, $Sr_3SiO_5:Eu$, $Ba_3SiO_5:Eu$, $Li_2SrSiO_4:Eu$, $Sr_2Ga_2SiO_7:Eu$, $Sr_3(BO_3)_2:Eu$, $\alpha$-SiAlON:Eu, $Sr_3SiO_5:Ce$, and $ZnS:Mn$.

Examples of the fluorescent body that emits infrared light when being excited by the near-ultraviolet light include $LiEuW_2O_8$, $NaEuW_2O_8$, $KEuW_2O_8$, $Li_5EuW_{416}$, $Na_5EuW_4O_{16}$, $K_5EuW_4O_{16}$, $Ca_2ZnSi_2O_7:Eu$, $SrS:Eu$, $Sr_2Si_5N_8:Eu$, $Ba_2Si_5N_8:Eu$, $Sr_2P_2O_7:Eu,Mn$, $Ba_3MgSi_2O_8:Eu,Mn$, $CuAlS_2:Mn$, and $Ba_2ZnS_3:Mn$.

Examples of the fluorescent body that emits near-infrared light when being excited by the near-ultraviolet light to blue light include $Y_3Al_5O_{12}:Cr$, $BaMgAl_{10}O_{17}:Cr$, $Lu_3Ga_5O_{12}:Cr$, $Lu_3Al_5O_{12}:Cr$, $Y_3Ga_5O_{12}:Cr$, $Ga_2O_3:Cr$, $Y_3(Al,Ga)_5O_{12}:Cr$, $(Al,Ga)_2O_3:Cr$, $Gd_3Ga_5O_{12}:Cr$, $Gd_3(Al,Ga)_5O_{12}:Cr$, $SrSnO_3:Bi$, $Gd_3Sc_2Al_3O_{12}:Cr$, $Zn_3Ga_2Ge_2O_{10}:Cr$, $La_3GaGe_5O_{16}:Cr$, $ZnGa_2O_4:Cr$, and $Zn(Al,Ga)_2O_4:Cr$.

Examples of the near-infrared light-emitting fluorescent body include $Y_3Al_5O_{12}:Fe$, $Y_3Al_5O_{12}:Ce,Fe$, $BaMgAl_{10}O_{17}:Fe$, $BaMgAl_{10}O_{17}:Eu,Fe$, $ZnAl_2O_4:Fe$, $LiAl_5O_8:Fe$, $GdAlO_3:Fe$, $BeAl_2O_4:Fe$, $MgAl_2O_4:Fe$, $GdMgAl_{11}O_{19}:Fe$, $LaAlO_3:Fe$, $YAl_3(BO_3)_4:Fe$, $GdAl_3(BO_3)4:Fe$, $(Al,Ga)_2O_3:Fe$, and $(Al,Ga)_2O_3:Eu,Fe$. Further, these near-infrared light-emitting fluorescent bodies can be synthesized by using the $\beta$-alumina described in the disclosure as the raw material. Further, these near-infrared light-emitting fluorescent bodies can be synthesized by mixing at least one element of Pr, Sm, Yb, Er, Nd, Dy and Tm.

Further, the average particle diameter of the fluorescent bodies for use in the light source according to the disclosure is preferably 5 $\mu$m or less. Here, the average particle diameter of the fluorescent bodies can be defined as follows. Examples of the method for investigating the average particle diameter of particles (fluorescent body particles) include a method of measurement with a particle size distribution analyzer and a method of directly observation with an electron microscope.

Taking the case of investigation with the electron microscope as an example, the average particle diameter can be calculated as follows. Each section ($\cdots$, 0.8 to 1.2 $\mu$m, 1.3 to 1.7 $\mu$m, 1.8 to 2.2 $\mu$m, 6.8 to 7.2 $\mu$m, 7.3 to 7.7 $\mu$m, 7.8 to 8.2 $\mu$m, $\cdots$ or the like) of a variable of the particle diameter of the particles is represented by a class value ($\cdots$, 1.0 $\mu$m, 1.5 $\mu$m, 2.0 $\mu$m, $\cdots$, 7.0 $\mu$m, 7.5 $\mu$m, 8.0 $\mu$m, $\cdots$), which is denoted as $x_i$. Then, when a frequency of each variable observed with the electron microscope is represented by $f_i$, an average value A is expressed as follows.

$$A = \Sigma x_i f_i / \Sigma f_i = \Sigma x_i f_i / N$$

$$\Sigma f_i = N.$$

As described above, the near-infrared light-emitting fluorescent body according to the disclosure is suitable as a wavelength conversion material to be combined with an LED element that emits near-ultraviolet light having an excitation band wavelength. Therefore, when the near-infrared light-emitting fluorescent body is used for a light source for biochemical analysis, an excellent effect is obtained. In addition, because of having a small average particle diameter, the fluorescent body is suitable for, by being mixed with a resin, using the transmitted light emitted from the LED element as excitation light.

In the above experimental examples, the $\beta$-alumina to be used had a shape of Powder ca. 3 $\mu$m and is obtained from Kojundo Chemical Lab. Co., Ltd, and the starting raw material $\beta$-alumina may have a particle diameter of about 0.1 to 3 $\mu$m.

[Preparation of Light Source for Use in Biochemical Analyzer] Various light sources to which the fluorescent body according to the disclosure is applied will be described below.

**(Configuration Example 1)**

A light source was prepared by placing a transparent resin mixed with a fluorescent body on an LED element that emits near-ultraviolet light. In the light source according to Configuration Example 1, an LED element that emits the light having a wavelength of 340 nm was used as the LED element, and a fluororesin was used as the transparent resin. An upper portion of the LED module was covered with quartz glass, and only one LED element was incorporated therein.

As the fluorescent body, the near-infrared light-emitting fluorescent body synthesized by using the $\beta$-alumina (Na-n$Al_2O_3$:Fe), the near-ultraviolet light-emitting fluorescent body ($Y_2SiO_5$:Ce (P47)), the blue light-emitting fluorescent body (BaMg$Al_{10}O_{17}$:Eu (BAM)), the green light-emitting fluorescent body ((Sr,Ba,Mg)$_2SiO_4$:Eu (BOS)), and the infrared light-emitting fluorescent body (CaAlSiN$_3$:Eu (CASN)) were used.

The light source was prepared as follows. First, 8 mg of the near-infrared light-emitting fluorescent body (Na-n$Al_2O_3$: Fe) and 8 mg of the near-ultraviolet light-emitting fluorescent body ($Y_2SiO_5$: Ce) were weighed and mixed with 160 $\mu$l of the fluororesin. After mixing, the mixture was allowed to stand for about 1 day, and the fluororesin mixed with the near-infrared light-emitting fluorescent body and the ultraviolet light-emitting fluorescent body was potted on the quartz glass of the LED module. After being naturally dried for about 30 minutes, the fluororesin was baked at 50°C for 30 minutes to cure a surface of the fluororesin.

Next, 8 mg of each of the blue light-emitting fluorescent body (BaMg$Al_{10}O_{17}$:Eu (BAM)), the green light-emitting fluorescent body ((Sr,Ba,Mg)$_2SiO_4$:Eu (BOS)), and the infrared light-emitting fluorescent body (CaAlSiN$_3$:Eu (CASN)) were weighed and mixed with 240 $\mu$l of the fluororesin. The resin mixed with the blue light-emitting fluorescent body, the green light-emitting fluorescent body, and the infrared light-emitting fluorescent body was allowed to stand for about 1 day, and then was potted on a resin layer containing the already formed near-infrared light-emitting fluorescent body. Then, a two-layer structure was obtained, which included a layer in which the near-infrared light-emitting fluorescent body and the near-ultraviolet light-emitting fluorescent body were mixed, and a layer in which the blue light-emitting fluorescent body, the green light-emitting fluorescent body, and the infrared light-emitting fluorescent body were mixed.

After being naturally dried for about 30 minutes, the fluororesin was baked at 50°C for 30 minutes to cure the surface of the fluororesin. Thereafter, the fluororesin was naturally dried for several days to be cured, so as to prepare a light source.

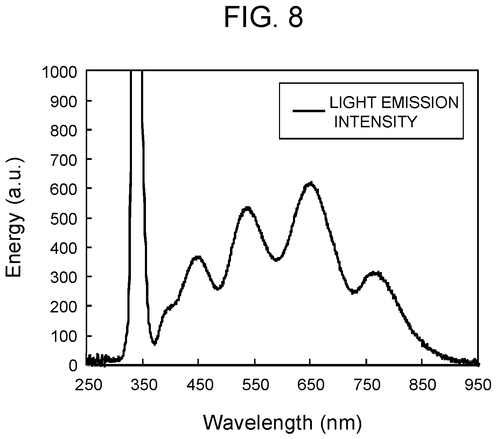

FIG. 8 shows a light emitting spectrum of the light source according to Configuration Example 1. As shown in FIG. 8, it was confirmed that near-infrared light emission has a mountain of a light emission intensity around 800 nm. As described above, the light source according to Configuration Example 1 is formed by combining the LED element and the fluorescent body having a wide light emission wavelength band. Since the above light source includes only one LED element, the luminance unevenness can be prevented, and the light source emits light in a wide wavelength region around near-infrared light. In addition, when the above light source is applied to an analyzer, the life of the light source is long and a maintenance cost of the analyzer can be reduced, unlike a case where a tungsten lamp is used as the light source. Further, in the light source according to Configuration Example 1, since the fluorescent body that emits the near-infrared light is contained in the resin layer closer to the LED element, the fluorescent body is often excited by the near-ultraviolet light and emits near-infrared light having a high light emission intensity.

**(Configuration Example 2)**

A light source was prepared by placing a transparent resin mixed with a fluorescent body on an LED element that emits near-ultraviolet light. In the light source according to Configuration Example 2, an LED element that emits the light having a wavelength of 340 nm and an LED element that emits the light having a wavelength of 405 nm were used as the LED element, and a fluororesin was used as the transparent resin. An upper portion of the LED module was covered with quartz glass, and one LED element (wavelength 340 nm) and one LED element (wavelength 405 nm) were incorporated therein.

As the fluorescent body, the near-infrared light-emitting fluorescent body ($Y_3(Al,Ga)_5O_{12}$:Cr) synthesized by using the β-alumina, the blue light-emitting fluorescent body (($Sr,Ca,Ba)_{10}(PO_4)_6Cl_2$:Eu (SCA)), the green light-emitting fluorescent body (($Sr,Ba,Mg)_2SiO_4$:Eu (BOS)), and the infrared light-emitting fluorescent body ($CaAlSiN_3$:Eu (CASN)) were used.

The light source was prepared as follows. First, 8 mg of the near-infrared light-emitting fluorescent body ($Y_3(Al,Ga)_5O_{12}$:Cr) was weighed and mixed with 80 μl of the fluororesin. After mixing, the mixture was allowed to stand for about 1 day, and the fluororesin mixed with the near-infrared light-emitting fluorescent body was potted on the quartz glass of the LED module. After being naturally dried for about 30 minutes, the fluororesin was baked at 50°C for 30 minutes to cure the surface of the fluororesin.

Next, 8 mg of each of the blue light-emitting fluorescent body (($Sr,Ca,Ba)_{10}(PO_4)_6Cl_2$:Eu (SCA)), the green light-emitting fluorescent body (($Sr,Ba,Mg)_2SiO_4$:Eu (BOS)), and the infrared light-emitting fluorescent body ($CaAlSiN_3$:Eu (CASN)) were weighed and mixed with 240 μl of the fluororesin.

In addition, $SiO_2$ fine particles (or $Al_2O_3$ fine particles) were mixed as a light diffusing material in the fluororesin. The resin mixed with the blue light-emitting fluorescent body, the green light-emitting fluorescent body, and the infrared light-emitting fluorescent body was allowed to stand for about 1 day, and then was potted on a resin layer containing the already formed near-infrared light-emitting fluorescent body. Then, a two-layer structure was obtained, which included a layer in which the near-infrared light-emitting fluorescent body was mixed, and a layer in which the blue light-emitting fluorescent body, the green light-emitting fluorescent body, and the infrared light-emitting fluorescent body were mixed.

After potting, the fluororesin was naturally dried for about 30 minutes, and then was baked at 50°C for 30 minutes to cure the surface of the fluororesin. Further, the prepared light source was baked at 80°C for 30 minutes to cure the fluororesin. The light emission of the prepared light source 1 was good as the light source for biochemical analysis, since the light power was improved by adding the LED element that emits the light having a wavelength of 405 nm.

**(Configuration Example 3)**

A light source was prepared by placing a transparent resin mixed with a fluorescent body on an LED element that emits near-ultraviolet light. In the light source according to Configuration Example 3, an LED element that emits the light having a wavelength of 340 nm was used as the LED element, and a fluororesin was used as the transparent resin. An upper portion of the LED module was covered with quartz glass, and three LED elements were incorporated therein.

As the fluorescent body, the near-infrared light-emitting fluorescent body synthesized by using the β-alumina ($BaAl_{12}O_{19}$:Fe), the near-ultraviolet light-emitting fluorescent body ($Y_2SiO_5$:Ce (P47)), the blue light-emitting fluorescent body ($BaMgAl_{10}O_{17}$:Eu (BAM)), the green light-emitting fluorescent body (($Sr,Ba,Mg)_2SiO_4$:Eu (BOS)), and the infrared light-emitting fluorescent body ($CaAlSiN_3$:Eu (CASN)) were used.

The light source was prepared as follows. First, 8 mg of the near-infrared light-emitting fluorescent body ($BaAl_{12}O_{19}$:Fe) and 8 mg of the near-ultraviolet light-emitting fluorescent body ($Y_2SiO_5$:Ce) were weighed and mixed with 160 μl of the fluororesin. After mixing, the mixture was allowed to stand for about 1 day, and the fluororesin mixed with the near-infrared light-emitting fluorescent body and the ultraviolet light-emitting fluorescent body was potted on the quartz glass of the LED module. After being naturally dried for about 30 minutes, the fluororesin was baked at 50°C for 30 minutes to cure the surface of the fluororesin.

Next, 8 mg of each of the blue light-emitting fluorescent body ($BaMgAl_{10}O_{17}$:Eu (BAM)), the green light-emitting fluorescent body (($Sr,Ba,Mg)_2SiO_4$:Eu (BOS)), and the infrared light-emitting fluorescent body ($CaAlSiN_3$:Eu (CASN)) were weighed and mixed with 240 μl of the fluororesin. The resin mixed with the blue light-emitting fluorescent body, the green light-emitting fluorescent body, and the infrared light-emitting fluorescent body was allowed to stand for about 1 day, and then was potted on a resin layer containing the already formed near-infrared light-emitting fluorescent body. Then, a two-layer structure was obtained, which included a layer in which the near-infrared light-emitting fluorescent body and the near-ultraviolet light-emitting fluorescent body were mixed, and a layer in which the blue light-emitting fluorescent body, the green light-emitting fluorescent body, and the infrared light-emitting fluorescent body were mixed.

After being naturally dried for about 30 minutes, the fluororesin was baked at 50°C for 30 minutes to cure the surface of the fluororesin. Further, after being baked at 80°C for 30 minutes, the fluororesin was baked at 150°C for 60 minutes to be cured. The light source prepared as above was good as the light source for biochemical analysis.

**(Configuration Example 4)**

A light source was prepared by placing a transparent resin mixed with a fluorescent body on an LED element that emits near-ultraviolet light. In the light source according to Configuration Example 4, an LED element that emits the light having a wavelength of 340 nm and an LED element that emits the light having a wavelength of 405 nm were used as the LED element, and a fluororesin was used as the transparent resin. An upper portion of the LED module was covered with quartz glass, and three LED elements (wavelength 340 nm) and one LED element (wavelength 405 nm) were incorporated therein.

As the fluorescent body, the near-infrared light-emitting fluorescent body ($Y_3(Al,Ga)_5O_{12}$:Cr) synthesized by using the β-alumina, the blue light-emitting fluorescent body (($Sr,Ca,Ba)_{10}(PO_4)_6Cl_2$:Eu (SCA)), the green light-emitting fluorescent body (($Sr,Ba,Mg)_2SiO_4$:Eu (BOS)), and the infrared light-emitting fluorescent body ($CaAlSiN_3$:Eu (CASN)) were used.

The light source was prepared as follows. First, 8 mg of the near-infrared light-emitting fluorescent body ($Y_3(Al,Ga)_5O_{12}$:Cr) was weighed and mixed with 80 μl of the fluororesin. After mixing, the mixture was allowed to stand for about 1 day, and the fluororesin mixed with the near-infrared light-emitting fluorescent body was potted on the quartz glass of the LED module. After being naturally dried for about 30 minutes, the fluororesin was baked at 50°C for 30 minutes to cure the surface of the fluororesin.

Next, 8 mg of each of the blue light-emitting fluorescent body (($Sr,Ca,Ba)_{10}(PO_4)_6Cl_2$:Eu (SCA)), the green light-emitting fluorescent body (($Sr,Ba,Mg)_2SiO_4$:Eu (BOS)), and the infrared light-emitting fluorescent body ($CaAlSiN_3$:Eu (CASN)) were weighed and mixed with 240 μl of the fluororesin.

In addition, $SiO_2$ fine particles (or $Al_2O_3$ fine particles) were mixed as a light diffusing material in the fluororesin. The resin mixed with the blue light-emitting fluorescent body, the green light-emitting fluorescent body, and the infrared light-emitting fluorescent body was allowed to stand for about 1 day, and then was potted on a resin layer containing the already formed near-infrared light-emitting fluorescent body. Then, a two-layer structure was obtained, which included a layer in which the near-infrared light-emitting fluorescent body was mixed, and a layer in which the blue light-emitting fluorescent body, the green light-emitting fluorescent body, and the infrared light-emitting fluorescent body were mixed.

After potting, the fluororesin was naturally dried for about 30 minutes, and then was baked at 50°C for 30 minutes to cure the surface of the fluororesin. Further, the prepared light source was baked at 80°C for 30 minutes and then at 200°C for 60 minutes to cure the fluororesin. The light emission of the prepared light source 1 was good as the light source for biochemical analysis, since the light power was improved by adding the LED element that emits the light having a wavelength of 405 nm.

**(Configuration Example 5)**

A light source was prepared by placing a transparent resin mixed with a fluorescent body on an LED element that emits near-ultraviolet light. In the light source according to Configuration Example 5, an LED element that emits the light having a wavelength of 340 nm and an LED element that emits the light having a wavelength of 405 nm were used as the LED element, and a fluororesin was used as the transparent resin. An upper portion of the LED module was covered with quartz glass, and one LED element (wavelength 340 nm) and one LED element (wavelength 405 nm) were incorporated therein.

As the fluorescent body, the near-infrared light-emitting fluorescent body ($BaAl_{12}O_{19}$:Fe) synthesized by using the β-alumina, the blue light-emitting fluorescent body (($Sr,Ca,Ba)_{10}(PO_4)_6Cl_2$:Eu (SCA)), the green light-emitting fluorescent body (($Sr,Ba,Mg)_2SiO_4$:Eu (BOS)), and the infrared light-emitting fluorescent body ($CaAlSiN_3$:Eu (CASN)) were used.

The light source was prepared as follows. First, 8 mg of the near-infrared light-emitting fluorescent body ($BaAl_{12}O_{19}$:Fe) was weighed and mixed with 80 μl of the fluororesin. After mixing, the mixture was allowed to stand for about 1 day, and the fluororesin mixed with the near-infrared light-emitting fluorescent body was potted on the quartz glass of the LED module. After being naturally dried for about 30 minutes, the fluororesin was baked at 50°C for 30 minutes to cure the surface of the fluororesin.

Next, 8 mg of each of the blue light-emitting fluorescent body (($Sr,Ca,Ba)_{10}(PO_4)_6Cl_2$:Eu (SCA)), the green light-emitting fluorescent body (($Sr,Ba,Mg)_2SiO_4$:Eu (BOS)), and the infrared light-emitting fluorescent body ($CaAlSiN_3$:Eu (CASN)) were weighed and mixed with 240 μl of the fluororesin.

In addition, $SiO_2$ fine particles (or $Al_2O_3$ fine particles) were mixed as a light diffusing material in the fluororesin. The resin mixed with the blue light-emitting fluorescent body, the green light-emitting fluorescent body, and the infrared light-emitting fluorescent body was allowed to stand for about 1 day, and then was potted on a resin layer containing the already formed near-infrared light-emitting fluorescent body. Then, a two-layer structure was obtained, which included a layer in which the near-infrared light-emitting fluorescent body was mixed, and a layer in which the blue light-emitting fluorescent body, the green light-emitting fluorescent body, and the infrared light-emitting fluorescent body were mixed.

After potting, the fluororesin was naturally dried for about 30 minutes, and then was baked at 50°C for 30 minutes to cure the surface of the fluororesin. Further, the prepared light source was baked at 80°C for 30 minutes and then at 200°C for 60 minutes to cure the fluororesin. The light emission of the prepared light source 1 was good as the light source for biochemical analysis, since the light power was improved by adding the LED element that emits the light having a wavelength of 405 nm.

**[Applications of Light Source]** The light source according to the disclosure can be used, for example, a light source for an analytical instrument such as a spectrophotometer, and a light source for growing a plant, in addition to the light source for the biochemical analyzer. Further, the fluorescent body according to the disclosure can be used as a fluorescent material for living body observation, a wavelength conversion material for solar cells, and the like.

The disclosure is not limited to the examples described above, and includes various modifications. For example, the examples described above have been described in detail for easy understanding of the disclosure, and the disclosure is not necessarily limited to those including all the configurations described above. Further, a part of the configuration of one example can be replaced with the configuration of another example, and the configuration of another example can be added to the configuration of one example. In addition, a part of the configuration of each example may be added, deleted, or replaced with another configuration.

**Reference Signs List**

    1 Light source
    2 LED module
    3 Transparent resin
    4 LED element
    5 Heat sink
    6 Wiring
    7 Fluorescent body

All publications, patents, and patent applications cited in the present description are hereby incorporated in the present description by reference as they are.

**Claims**

**1.** A fluorescent body produced by firing a raw material comprising:

an alumina; and
at least one among Fe, Cr, Bi, Tl, Ce, Tb, Eu, and Mn, wherein
the raw material contains 6.1 to 15.9 wt% of sodium with respect to a total amount of the raw material.

**2.** The fluorescent body according to claim 1, wherein the alumina is β-alumina.

**3.** The fluorescent body according to claim 2, wherein the β-alumina contains 6.0 to 7.0 wt% of the sodium.

**4.** The fluorescent body according to claim 1, wherein the raw material contains 50 wt% or more of the β-alumina.

**5.** The fluorescent body according to claim 2, wherein a particle diameter of the β-alumina is within a range of 0.1 to 3 μm.

**6.** The fluorescent body according to claim 1, wherein the raw material contains at least Fe.

**7.** The fluorescent body according to claim 1, wherein the raw material contains at least Cr.

**8.** The fluorescent body according to claim 1, wherein the raw material is fired at 1,350°C or higher.

**9.** A fluorescent body having a peak of light emission intensity in a range of 760 to 790 nm, a quantum efficiency of 50% or more, and an absorptance of 25% or more.

**10.** The fluorescent body according to claim 9, wherein the absorptance is 30% or more.

**11.** The fluorescent body according to claim 9, wherein a full width at half maximum of the light emission intensity is 50 nm or more.

**12.** The fluorescent body according to claim 9, wherein a particle diameter is within a range of 2.4 to 5.3 μm.

**13.** A fluorescent body particle group comprising:

a plurality of the fluorescent bodies according to claim 9, wherein
an average particle diameter of the fluorescent bodies is 5 μm or less.

**14.** The fluorescent body according to claim 9, wherein the fluorescent body is excited by near-ultraviolet light to emit near-infrared light.

**15.** A light source comprising:

the fluorescent body according to claim 14; and
an LED element that emits near-ultraviolet light.

16. The light source according to claim 15, further comprising:

an LED module including the LED element; and
a resin layer containing the fluorescent body, and provided on a path of the light emitted by the LED element.

17. The light source according to claim 16, further comprising:
a resin layer stacked on the resin layer, and containing another fluorescent body having a wavelength of light different from that of the light emitted from the fluorescent body.

18. The light source according to claim 17, wherein
a resin layer containing the fluorescent body that emits near-infrared light is formed on a side closer to the LED element than the resin layer containing another fluorescent body.

19. A biochemical analyzer using the light source according to claim 15.

# FIG. 1

# FIG. 2

| Item | Composition | Raw material composition | | | | |
|---|---|---|---|---|---|---|
| | | $BaCO_3$ (g) | $Na_2CO_3$ (g) | $Al_2O_3$ (g) | $FeCl_2 \cdot 4H_2O$ (mg) | Flux (mg) |
| Comparative Example 1 | $BaAl_{12}O_{19}$:Fe(α-alumina) | 1.22 | - | 3.77 | 10 | 5 |
| Comparative Example 2 | $BaAl_{12}O_{19}$:Fe(fired alumina) | 1.22 | - | 3.65 | 120 | 5 |
| Comparative Example 3 | $BaAl_{12}O_{19}$:Fe(fired alumina) | 0.47 | - | 1.45 | 47 | 27 |
| Comparative Example 4 | $BaAl_{12}O_{19}$:Fe(fired alumina) | 0.43 | - | 1.49 | 24 | 55 |
| Comparative Example 5 | $BaAl_{12}O_{19}$:Fe(fired alumina) | 0.38 | - | 1.48 | 24 | 110 |
| Comparative Example 6 | $BaAl_{12}O_{19}$:Fe(fired alumina) | 0.39 | - | 1.49 | 8 | 110 |
| Comparative Example 7 | $BaAl_{12}O_{19}$:Fe(fired alumina) | 0.48 | - | 1.49 | 10 | 25 |
| Comparative Example 8 | $BaAl_{12}O_{19}$:Fe(fired alumina) | 0.39 | - | 1.50 | 4.9 | 111 |
| Comparative Example 9 | $BaAl_{12}O_{19}$:Fe(fired alumina) | 0.39 | - | 1.50 | 2.5 | 111 |
| Comparative Example 10 | $Na-nAl_2O_3$:Fe(fused alumina) | | 0.42 | 0.92 | 36 | 190 |
| Comparative Example 11 | $Na-nAl_2O_3$:Fe(fused alumina) | | 2.17 | 2.32 | 41 | 470 |
| Comparative Example 12 | $Na-nAl_2O_3$:Fe(β-alumina) | - | 1.08 | 1.15 | 9 | 260 |
| Example 1 | $BaAl_{12}O_{19}$:Fe(β-alumina) | 0.38 | - | 1.48 | 30 | 110 |
| Example 2 | $BaAl_{12}O_{19}$:Fe(β-alumina) | 0.38 | - | 1.48 | 47 | 110 |
| Example 3 | $BaAl_{12}O_{19}$:Fe(β-alumina) | 0.43 | - | 1.45 | 47 | 55 |
| Example 4 | $BaAl_{12}O_{19}$:Fe(β-alumina) | 0.43 | - | 1.49 | 8 | 55 |
| Example 5 | $BaAl_{12}O_{19}$:Fe(β-alumina) | 0.43 | - | 1.48 | 24 | 55 |
| Example 6 | $Na-nAl_2O_3$:Fe(β-alumina) | - | 0.42 | 1.11 | 8 | 55 |
| Example 7 | $Na-nAl_2O_3$:Fe(β-alumina) | - | - | 1.11 | 8 | 55 |
| Example 8 | $Na-nAl_2O_3$:Fe(β-alumina) | - | 0.27 | 1.15 | 9 | 260 |
| Example 9 | $Na-nAl_2O_3$:Fe(β-alumina) | - | 0.27 | 1.15 | 23 | 260 |
| Example 10 | $Na-nAl_2O_3$:Fe(β-alumina) | - | 0.27 | 1.15 | 23 | - |
| Example 11 | $Na-nAl_2O_3$:Fe(β-alumina) | - | 0.27 | 1.15 | 23 | 260 |
| Example 12 | $Na-nAl_2O_3$:Fe(β-alumina) | - | 0.27 | 1.15 | 23 | 260 |
| Example 13 | $Na-nAl_2O_3$:Fe(fired alumina) | - | 0.42 | 1.11 | 8 | 210 |

| Item | Composition | Raw material composition | | | | |
|---|---|---|---|---|---|---|
| | | $CaCO_3$ (g) | $Na_2CO_3$ (g) | $Al_2O_3$ (g) | $FeCl_2 \cdot 4H_2O$ (mg) | Flux (mg) |
| Example 14 | $CaAl_{12}O_{19}$:Fe(β-alumina) | 0.23 | - | 1.59 | 8 | 59 |

| Item | Composition | Raw material composition | | | | |
|---|---|---|---|---|---|---|
| | | $SrCO_3$ (g) | $Na_2CO_3$ (g) | $Al_2O_3$ (g) | $FeCl_2 \cdot 4H_2O$ (mg) | Flux (mg) |
| Example 15 | $SrAl_{12}O_{19}$:Fe(β-alumina) | 0.34 | - | 1.59 | 8 | 59 |

# FIG. 3

| Item | Composition | Firing condition | | |
|---|---|---|---|---|
| | | Firing atmosphere | Firing temperature (°C) | Firing time (h) |
| Comparative Example 1 | $BaAl_{12}O_{19}$:Fe(α-alumina) | Air atmosphere | 1200 | 2 |
| Comparative Example 2 | $BaAl_{12}O_{19}$:Fe(fired alumina) | Air atmosphere | 1200 | 2 |
| Comparative Example 3 | $BaAl_{12}O_{19}$:Fe(fired alumina) | Air atmosphere | 1450 | 2 |
| Comparative Example 4 | $BaAl_{12}O_{19}$:Fe(fired alumina) | Air atmosphere | 1450 | 2 |
| Comparative Example 5 | $BaAl_{12}O_{19}$:Fe(fired alumina) | Air atmosphere | 1450 | 2 |
| Comparative Example 6 | $BaAl_{12}O_{19}$:Fe(fired alumina) | Air atmosphere | 1450 | 2 |
| Comparative Example 7 | $BaAl_{12}O_{19}$:Fe(fired alumina) | Air atmosphere | 1450 | 2 |
| Comparative Example 8 | $BaAl_{12}O_{19}$:Fe(fired alumina) | Air atmosphere | 1450 | 2 |
| Comparative Example 9 | $BaAl_{12}O_{19}$:Fe(fired alumina) | Air atmosphere | 1450 | 2 |
| Comparative Example 10 | $Na-nAl_2O_3$:Fe(fused alumina) | Air atmosphere | 1450 | 2 |
| Comparative Example 11 | $Na-nAl_2O_3$:Fe(fused alumina) | Air atmosphere | 1450 | 2 |
| Comparative Example 12 | $Na-nAl_2O_3$:Fe(β-alumina) | Air atmosphere | 1450 | 2 |
| Example 1 | $BaAl_{12}O_{19}$:Fe(β-alumina) | Air atmosphere | 1450 | 2 |
| Example 2 | $BaAl_{12}O_{19}$:Fe(β-alumina) | Air atmosphere | 1450 | 2 |
| Example 3 | $BaAl_{12}O_{19}$:Fe(β-alumina) | Air atmosphere | 1450 | 2 |
| Example 4 | $BaAl_{12}O_{19}$:Fe(β-alumina) | Air atmosphere | 1450 | 2 |
| Example 5 | $BaAl_{12}O_{19}$:Fe(β-alumina) | Air atmosphere | 1450 | 2 |
| Example 6 | $Na-nAl_2O_3$:Fe(β-alumina) | Air atmosphere | 1450 | 2 |
| Example 7 | $Na-nAl_2O_3$:Fe(β-alumina) | Air atmosphere | 1450 | 2 |
| Example 8 | $Na-nAl_2O_3$:Fe(β-alumina) | Air atmosphere | 1450 | 2 |
| Example 9 | $Na-nAl_2O_3$:F(β-alumina) | Air atmosphere | 1450 | 2 |
| Example 10 | $Na-nAl_2O_3$:Fe(β-alumina) | Air atmosphere | 1450 | 2 |
| Example 11 | $Na-nAl_2O_3$:Fe(β-alumina) | Air atmosphere | 1350 | 2 |
| Example 12 | $Na-nAl_2O_3$:Fe(β-alumina) | Air atmosphere | 1500 | 2 |
| Example 13 | $Na-nAl_2O_3$:Fe(fired alumina) | Air atmosphere | 1450 | 2 |

| Item | Composition | Firing condition | | |
|---|---|---|---|---|
| | | Firing atmosphere | Firing temperature (°C) | Firing time (h) |
| Example 14 | $CaAl_{12}O_{19}$:Fe(β-alumina) | Air atmosphere | 1450 | 2 |

| Item | Composition | Firing condition | | |
|---|---|---|---|---|
| | | Firing atmosphere | Firing temperature (°C) | Firing time (h) |
| Example 15 | $SrAl_{12}O_{19}$:Fe(β-alumina) | Air atmosphere | 1450 | 2 |

# FIG. 4

| Item | Composition | Particle diameter (μm) | Quantum efficiency (%) | Absorptance (%) | Light emission wavelength (nm) | Light emission intensity (a.u.) |
|---|---|---|---|---|---|---|
| Comparative Example 1 | $BaAl_{12}O_{19}$:Fe(α-alumina) | - | 1 | 10 | - | - |
| Comparative Example 2 | $BaAl_{12}O_{19}$:Fe(fired alumina) | - | 17 | 61 | 790 | 178 |
| Comparative Example 3 | $BaAl_{12}O_{19}$:Fe(fired alumina) | - | 40 | 35 | 788 | 255 |
| Comparative Example 4 | $BaAl_{12}O_{19}$:Fe(fired alumina) | - | 73 | 26 | 787 | 327 |
| Comparative Example 5 | $BaAl_{12}O_{19}$:Fe(fired alumina) | - | 71 | 29 | 785 | 361 |
| Comparative Example 6 | $BaAl_{12}O_{19}$:Fe(fired alumina) | 6.5 | 104 | 16 | 787 | 264 |
| Comparative Example 7 | $BaAl_{12}O_{19}$:Fe(fired alumina) | - | 112 | 15 | 788 | 301 |
| Comparative Example 8 | $BaAl_{12}O_{19}$:Fe(fired alumina) | - | 119 | 12 | 784 | 262 |
| Comparative Example 9 | $BaAl_{12}O_{19}$:Fe(fired alumina) | - | 121 | 8 | 783 | 177 |
| Comparative Example 10 | $Na\text{-}nAl_2O_3$:Fe(fused alumina) | - | 3 | 40 | 766 | 27 |
| Comparative Example 11 | $Na\text{-}nAl_2O_3$:Fe(fused alumina) | - | 20 | 35 | 772 | 135 |
| Comparative Example 12 | $Na\text{-}nAl_2O_3$:Fe(β-alumina) | 5.9 | 2 | 17 | 779 | 18 |
| Example 1 | $BaAl_{12}O_{19}$:Fe(β-alumina) | 5.3 | 69 | 46 | 771 | 556 |
| Example 2 | $BaAl_{12}O_{19}$:Fe(β-alumina) | 3.7 | 52 | 55 | 777 | 511 |
| Example 3 | $BaAl_{12}O_{19}$:Fe(β-alumina) | 2.6 | 52 | 54 | 775 | 494 |
| Example 4 | $BaAl_{12}O_{19}$:Fe(β-alumina) | 2.4 | 90 | 31 | 771 | 503 |
| Example 5 | $BaAl_{12}O_{19}$:Fe(β-alumina) | 3.2 | 79 | 38 | 769 | 533 |
| Example 6 | $Na\text{-}nAl_2O_3$:Fe(β-alumina) | 4.7 | 76 | 37 | 770 | 503 |
| Example 7 | $Na\text{-}nAl_2O_3$:Fe(β-alumina) | 2.2 | 88 | 26 | 773 | 413 |
| Example 8 | $Na\text{-}nAl_2O_3$:Fe(β-alumina) | 3.8 | 90 | 34 | 770 | 530 |
| Example 9 | $Na\text{-}nAl_2O_3$:Fe(β-alumina) | 3.7 | 45 | 79 | 771 | 646 |
| Example 10 | $Na\text{-}nAl_2O_3$:Fe(β-alumina) | 4.2 | 56 | 43 | 771 | 439 |
| Example 11 | $Na\text{-}nAl_2O_3$:Fe(β-alumina) | 3.3 | 61 | 40 | 771 | 464 |
| Example 12 | $Na\text{-}nAl_2O_3$:Fe(β-alumina) | 4.8 | 63 | 59 | 771 | 682 |
| Example 13 | $Na\text{-}nAl_2O_3$:Fe(fired alumina) | - | 78 | 31 | 770 | 410 |

| Item | Composition | Particle diameter (μm) | Quantum efficiency (%) | Absorptance (%) | Light emission wavelength (nm) | Light emission intensity (a.u.) |
|---|---|---|---|---|---|---|
| Example 14 | $CaAl_{12}O_{19}$:Fe(β-alumina) | - | 98 | 25 | 767 | 469 |

| Item | Composition | Particle diameter (μm) | Quantum efficiency (%) | Absorptance (%) | Light emission wavelength (nm) | Light emission intensity (a.u.) |
|---|---|---|---|---|---|---|
| Example 15 | $SrAl_{12}O_{19}$:Fe(β-alumina) | - | 99 | 28 | 771 | 478 |

FIG. 5

# FIG. 6

# FIG. 7

# FIG. 8

## INTERNATIONAL SEARCH REPORT

| International application No. |
|---|
| PCT/JP2019/015318 |

A.  CLASSIFICATION OF SUBJECT MATTER
Int.Cl.  C09K11/64(2006.01)i, H01L33/50(2010.01)i
According to International Patent Classification (IPC) or to both national classification and IPC

B.  FIELDS SEARCHED

Minimum documentation searched (classification system followed by classification symbols)
Int.Cl.  C09K11/64, H01L33/50

| Documentation searched other than minimum documentation to the extent that such documents are included in the fields searched | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)
CAplus/REGISTRY (STN)

C.  DOCUMENTS CONSIDERED TO BE RELEVANT

| Category* | Citation of document, with indication, where appropriate, of the relevant passages | Relevant to claim No. |
|---|---|---|
| X | NETO J. M. et al., "Iron luminescence thermal effects in sodium beta" -alumina", Journal of Solid State Chemistry, 1986, 65, 199-204 | 1-6, 8-19 |
| X | MARIOTTO G. et al., "A comparative analysis of the luminescence of the Cr3+ ion in sodium beta- and beta" -alumina crystals", Solid State Ionics, 1990, 40/41, 328-330 | 1-5, 7-19 |

☒  Further documents are listed in the continuation of Box C.  ☐  See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 21 June 2019 (21.06.2019) | 09 July 2019 (09.07.2019) |

| Name and mailing address of the ISA/ | Authorized officer |
|---|---|
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**

International application No.

PCT/JP2019/015318

C (Continuation). DOCUMENTS CONSIDERED TO BE RELEVANT

| Category* | Citation of document, with indication, where appropriate, of the relevant passages | Relevant to claim No. |
|---|---|---|
| X | OKAMURA, Hidekazu et al., "Luminescence spectra of Cr3+ in Na1-xKx beta-alumina crystals", Solid State Ionics, 1990, 40/ 41, 118-120 | 1-5, 7-19 |
| X | OKAMURA, Hidekazu et al., "Luminescence spectra of Cr3+ ions in Na1-xKx and Na1-xTlx beta-alumina crystals", Solid State Ionics, 1992, 58, 77-84 | 1-5, 7-19 |
| X | HATTORI, Takeshi et al., "Luminescence from Cr3+ ions in mixed-cation beta-alumina crystals", Solid State Ionics, 1994, 70/71, 471-475 | 1-5, 7-19 |
| X | HATTORI, Takeshi et al., "Decay of the luminescence from Cr3+ ions in mixed-cation beta-aluminas", Solid State Ionics, 1995, 79, 21-25 | 1-5, 7-19 |
| X | JP 2003-105334 A (TOSOH CORP.) 09 April 2003, claims 1-3, examples (Family: none) | 1-5, 8-19 |
| X | JP 2003-268366 A (NICHIA CHEMICAL INDUSTRIES, LTD.) 25 September 2003, claims 1-3, example 8 (Family: none) | 1-5, 8-19 |
| X | JP 2013-519738 A (OCEAN'S KING LIGHTING SCIENCE & TECHNOLOGY CO., LTD.) 30 May 2013, claims 1-12, examples & US 2012/0286205 A1 claims 1-12, examples & WO A1 & EP 2535393 A1 & CN 102575164 A | 1-5, 8-19 |
| X | JP 5-093187 A (NICHIA CHEMICAL INDUSTRIES, LTD.) 16 April 1993, claims 1-2, example 2 (Family: none) | 1-5, 8-19 |
| X | JP 49-062391 A (TOKYO SHIBAURA ELECTRIC CO., LTD.) 17 June 1974, claims, example 2 (Family: none) | 1-5, 8-19 |
| A | JP 2007-145902 A (HITACHI MEDICAL CORPORATION) 14 June 2007, claims 1-3, examples (Family: none) | 1-19 |

Form PCT/ISA/210 (continuation of second sheet) (January 2015)

**INTERNATIONAL SEARCH REPORT**

| International application No. |
|---|
| PCT/JP2019/015318 |

<Concerning the subject of the search>

The invention in claims 1-8 pertains to a "phosphor manufactured by firing a raw material which contains alumina and at least one among Fe, Cr, Bi, Tl, Ce, Tb, Eu, and Mn and contains 6.1-15.9 wt% of sodium with respect to all raw materials."

In addition, the invention in claims 9-19 pertains to a "phosphor having a fluorescence intensity peak within a range of 760-790 nm, quantum efficiency of at least 50%, and absorptance of at least 25%."

(1) The invention in claims 9-19 pertains to a phosphor of which the composition and crystal structure are not specified at all and which is specified only by physical properties, but it is technically known that the physical properties of a phosphor are determined greatly depending on the composition and crystal structure of the phosphor.

In addition, the description of this application merely discloses a phosphor manufactured by mixing and firing a raw material which contains alumina, sodium, and at least one among Fe, Cr, Bi, Tl, Ce, Tb, Eu, and Mn such that the composition of a target material is BaAl12O19:Fe, CaAl12O19:Fe, SrAl12O19:Fe, or Na-nAl2O3: Fe, and does not disclose any phosphor other than said phosphor at all.

(2) In relation to the invention in claims 1-8, "alumina" generally means an aluminum oxide, but claims 2-5 describe that the alumina is β-alumina, and the description (paragraph [0053]) indicates the wordings "β-alumina contains Na in an alumina raw material, and is a mixed phase product (sintered product) of NaAl11O17 (β phase) and NaAl5O8 (β″ phase). Here, β phase and β″ phase are collectively called β-alumina (or β-Al2O3). Here, in the present description, "β-alumina" means alumina which contains at least 50% of β-alumina component and has β-alumina as a main component." Thus, it is understood that "alumina" includes an aluminum oxide other than pure aluminum oxide, but the scope of "alumina" is unclear, except for aluminum oxide.

(3) In relation to the invention in claims 1-8, it is calculated from the description of this application that 11.6 wt% of sodium is contained in the raw material of comparative example 10, 4.8 wt% of sodium is contained in the raw materials of examples 1-3 and 5, 3.9 wt% of sodium is contained in the raw material of example 4, 16.0 wt% of sodium is contained in the raw material of example 6, 4.3 wt% of sodium is contained in the raw material of example 7, 11.3 wt% of sodium is contained in the raw materials of examples 8, 9, 11, and 12, 13 wt% of sodium is contained in the raw materials of examples 10 and 13, and 5 wt% of sodium is contained in the raw materials of examples 14 and 15.

Thus, even among raw materials containing 6.1-15.9 wt% of sodium, there is a case (e.g., comparative example 10) in which the effect of the present invention is not exhibited, and to the contrary, even among raw materials (e.g., examples 1-15) containing less than 6.1 wt% or more than 15.9 wt% of sodium, there is a case in which the effect of the present invention is exhibited. After all, neither the technical meaning of the sodium content nor the range of the sodium content intended by the applicant cannot be understood.

Thus, the description is not disclosed clearly or sufficiently enough for a person skilled in the art to carry out the invention in claims 1-19, and thus does not satisfy the requirements of PCT Article 5.

In addition, as aforementioned, since the scope of the invention intended by the applicant cannot be clearly comprehended, the inventions in claims 1-19 do not comply with the requirement for clarity under PCT Article 6.

Thus, the prior art document search was carried out for a phosphor manufactured by firing a raw material which contains alumina, sodium, and at least one among Fe, Cr, Bi, Tl, Ce, Tb, Eu, and Mn in amounts of no less than amounts for activation thereof.

Form PCT/ISA/210 (extra sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001352101 A
- JP 2015060921 A
- JP 2016103556 A
- JP 2018090854 A

**Non-patent literature cited in the description**

- *React. Kinet. Catal. Lett.,* 2005, vol. 86 (2), 299-306
- *J. Electrochem. Soc.,* 2000, vol. 147 (11), 4368-4373
- *Displays,* 1999, vol. 19, 197-203